# EUROPÄISCHE PATENTSCHRIFT

(11) **EP 0 650 504 B1**
(45) Veröffentlichungstag und Bekanntmachung des Hinweises auf die Patenterteilung: **12.11.1997**
(21) Anmeldenummer: 93912646.2
(22) Anmeldetag: 02.07.1993
(51) Int. Cl.: C08G 59/40, C08G 18/00, C08G 59/02, C08L 63/00, C08G 59/30, C08G 59/38, H01L 23/29

(54) **VERFAHREN ZUR HERSTELLUNG EINER FLAMMWIDRIG EINGESTELLTEN EPOXIDHARZFORMMASSE**
PROCESS FOR PRODUCING A FLAME-RESISTANT EPOXY RESIN MOLDING MATERIAL
PROCEDE DE PRODUCTION D'UN MATERIAU MOULABLE IGNIFUGE A BASE DE RESINES EPOXY

(30) Priorität: 17.07.1992 DE 4223632
(43) Veröffentlichungstag der Anmeldung: 03.05.1995
(73) Patentinhaber: SIEMENS AKTIENGESELLSCHAFT, 80333 München (DE)
(72) Erfinder: MARKERT, Helmut, D-90461 Nürnberg (DE); DONNER, Peter, D-91334 Hemhofen (DE); KRETZSCHMAR, Klaus, D-91054 Erlangen (DE); MÜLLER, Klaus, D-93051 Regensburg (DE); SCHREYER, Michael, D-91085 Weisendorf (DE)
(86) Internationale Anmeldenummer: DE9300584
(87) Internationale Veröffentlichungsnummer: WO9402528

(56) Entgegenhaltungen:
- EP-A- 0 113 575
- WO-A-90/15089
- US-A- 3 028 251
- PATENT ABSTRACTS OF JAPAN vol. 11, no. 3 (C-395)(2450) 7. Januar 1987
- SIEMENS FORSCHUNGS UND ENTWICKLUNGSBERICHTE Bd. 16, Nr. 3, 1987, Seiten 105-111 MARKERT H. ET AL 'Network polymers based on EPIC resins' siehe Seite 105, Absatz 2

## Beschreibung

Die Erfindung betrifft ein Verfahren zur Herstellung einer flammwidrig eingestellten, rieselfähigen, latent reaktiven, phenolisch härtbaren Epoxidharzformmasse zur Umhüllung von Bauelementen der Elektronik.

In der Elektronik werden zur Umhüllung von aktiven und passiven Bauelementen füllstoffhaltige Formmassen auf der Basis von Epoxidharzen verwendet. Beispiele für derartige Anwendungen sind die Umhüllung von Kondensatoren, Dioden, Transistoren, Leistungshalbleitern, Optokopplern, Speicherchips und Mikroprozessoren. Für diesen Zweck geeignete Epoxidharzformmassen müssen hohe Anforderungen an die Verarbeitungs- und Formstoffeigenschaften erfüllen. Dies betrifft insbesondere die Reinheit der Formmassen sowie das rheologische Verhalten und die Härtungseigenschaften bei der Verarbeitung als Transferpreßmassen mittels Spritz-Preß-Verfahren und ferner die mechanisch-thermischen Eigenschaften der Epoxidharzformstoffe und den langzeitstabilen Schutz der Bauelemente gegen aggressive Umgebungseinflüsse. Außerdem müssen die Epoxidharzformstoffe die hohen Forderungen der Elektronik an das flammwidrige Verhalten erfüllen und - bei der international üblichen Brennbarkeitsprüfung nach UL 94 - die Einstufung V-O bei einer Schichtstärke ≤ 1,6 mm erreichen.

Die Härtung von Epoxidharzformmassen kann mit chemisch unterschiedlichen Härterkomponenten durchgeführt werden, beispielsweise mit Carbonsäureanhydriden, Aminen oder Phenolen. Zur Umhüllung von elektronischen Bauelementen mittels Spritz-Preß-Verfahren haben sich jedoch mit silanisiertem Quarzgutmehl hochgefüllte, phenolisch härtbare Epoxidharz-Transferpreßmassen durchgesetzt.

Phenolisch härtbare Epoxidharz-Transferpreßmassen enthalten in der Regel 20 bis 30 % organische und 70 bis 80 % anorganische Stoffe. Die chemische Basis der Harzkomponenten besteht in den meisten Fällen aus Kresolnovolak-Epoxidharzen. Zur Härtung der Epoxidharze werden überwiegend Phenolnovolake verwendet; die Reaktionsbeschleunigung erfolgt beispielsweise mit Triphenylphosphin, Phenylphosphoniumborat und 2-Ethyl-4-methylimidazol. Zur Verbesserung des Low stress-Verhaltens werden siliconmodifizierte Epoxidharzkomponenten eingesetzt. Die flammwidrige Einstellung der Preßmassen erfolgt mit aromatischen Bromverbindungen, insbesondere mit Tetrabrombisphenol A-Epoxidharzen, die bei der Härtung chemisch in den Epoxidharzformstoff eingebaut werden. Zusätzlich dient Antimontrioxid als Synergist und erhöht die Wirksamkeit der bromierten Flammschutzmittel. Die flammwidrigen Eigenschaften der Epoxidharzformstoffe werden weiter durch einen hohen Gehalt an silanisierten Quarzgutfüllstoffen unterstützt; verwendet werden dabei sowohl splittrige Füllstoffe als auch Mischungen aus splittrigen und sphärischen Füllstoffen. Neuerdings werden zur Vermeidung von sogenannten weichen Ausfällen (saft errors) bei hochintegrierten Schaltungen synthetisch hergestellte α-strahlungsfreie Quarzgutfüllstoffe verwendet. Der hohe Gehalt an silanisiertem Quarzgutfüllstoff dient auch zur Verbesserung der mechanisch-thermischen Eigenschaften der Epoxidharzformstoffe, insbesondere zur Einstellung des Ausdehnungskoeffizienten.

Die Preßmassen enthalten auch noch geringe Mengen an Additiven, insbesondere Ruß und Verarbeitungshilfen, wie Stearate und Wachse.

Zur Herstellung der phenolisch härtbaren Epoxidharz-Transferpreßmassen werden die Harz- und Härterkomponenten in der Regel bei Temperaturen bis ca. 120°C, insbesondere durch Kneten auf einem Walzenstuhl oder durch Extrusion, beispielsweise mittels eines Schneckenkneters, in einen vorreagierten Zustand (B-stage) überführt und pulverisiert. Zur Verarbeitung der Transferpreßmassen mittels Spritz-Preß-Verfahren wird das Preßmassenpulver meist tablettiert, gegebenenfalls werden die Tabletten auf 80 bis 90°C vorgewärmt. Die Umhüllung der Bauelemente erfolgt im allgemeinen bei Formtemperaturen von 170 bis 190°C und einem Druck von 70 bis 200 bar, wobei die Preßmasse in der Form meist 60 bis 120 s lang gehärtet wird. Anschließend werden die Bauelemente entformt und in der Regel bei Temperaturen von 170 bis 190°C nachgehärtet.

Die mit bromhaltigen Flammschutzmitteln und Antimontrioxid flammwidrig eingestellten phenolisch härtbaren Epoxidharzformmassen, die hervorragende flammhemmende Eigenschaften besitzen, haben sich in der Elektronik bewährt. Wegen der schlechten Umweltverträglichkeit der bromierten aromatischen Verbindungen wird jedoch zunehmend die Substitution derartiger Epoxidharzformmassen gefordert. Die Gründe dafür sind, daß die genannten Verbindungen im Störfall, d.h. bei Brand oder Verschwelung, hochkorrosive bromierte Gase abspalten und biologisch schwer abbaubare bromierte Zersetzungsprodukte mit hohem toxikologisch-ökologischen Gefährdungspotential bilden. Außerdem sind Epoxidharzformstoffe, die bromierte Flammschutzmittel enthalten, für ein Recycling nicht geeignet, wenn eine weitere Streuung von gefährlichen Produkten vermieden werden soll. Darüber hinaus kann zukünftig die Entsorgung solcher Epoxidharzformstoffe durch Verbrennung, wegen der weiter steigenden Auflagen zur Luftreinhaltung, nur als Sondermüll mit technisch aufwendigen und wirtschaftlich unrentablen Verbrennungsverfahren durchgeführt werden. Gegen den Einsatz von Antimontrioxid spricht, daß diese Verbindung auf der Liste der krebserzeugenden Gefahrstoffe steht. Eine Gefährdung ist zwar bei dauerhafter Einbindung vernachlässigbar, im Brand- oder Verschwelungsfall bzw. bei Recyclingverfahren stellt freigesetztes Antimontrioxid - in Form von atembarem Staub - jedoch ein hohes Risiko dar.

Aufgabe der Erfindung ist es, einen Weg zur Herstellung halogenfreier Formmassen auf der Basis von Epoxidharzen aufzuzeigen, die den hohen Anforderungen der Elektronik an das flammwidrige Verhalten genügen und gleichzeitig die hohen Ansprüche an die Verarbeitungseigenschaften und die Formstoffeigenschaften erfüllen. Darüber hinaus sollen diese Formmassen umweltgerechte Eigenschaften besitzen, für das Recycling geeignet und - mit umweltschonenden Verbrennungsverfahren unter Energierückgewinnung - entsorgbar sein.

Dies wird erfindungsgemäß dadurch erreicht, daß aus einer Füllstoff enthaltenden, thermisch polymerisierbaren Reaktionsharzmischung von Polyepoxidharz, bestehend aus einer Mischung von di- und mehrfunktionellen Epoxidharzen, und Polyisocyanatharz mit einem Molverhältnis der Epoxidgruppen zu den Isocyanatgruppen > 1 - unter Verwendung von substituiertem Imidazol als Reaktionsbeschleuniger in einer Konzentration von 0,5 bis 2,5 %, bezogen auf Polyepoxidharz - bei Reaktionstemperaturen bis 200°C eine isocyanatgruppenfreie, latent reaktive prepolymere Epoxidharzmischung in Pulverform hergestellt wird, und daß die prepolymere Epoxidharzmischung mit einer pulverförmigen, Füllstoff enthaltenden Phenolharzmischung im Molverhältnis der Epoxidgruppen zu den phenolischen Hydroxylgruppen von 1:0,4 bis 1:1,1 vermischt wird, gegebenenfalls unter Zusatz von Additiven.

Beim erfindungsgemäßen Verfahren kann die prepolymere Epoxidharzmischung in verschiedener Weise hergestellt werden. Bei einer ersten Variante werden Polyepoxidharz, d.h. di- und mehrfunktionelle Epoxidharze, und Polyisocyanatharz sowie gegebenenfalls Additive in einem thermostatisierbaren und evakuierbaren Mischbehälter (als Aufbereitungs- und Reaktionskessel), der beispielsweise mit einem Hochleistungsrührer (mit Duplexknetschaufeln) ausgerüstet ist und eine kontinuierliche Temperaturmessung erlaubt, auf Temperaturen bis 100°C erwärmt und unter Rühren gemischt und entgast. In die Reaktionsharzmischung werden portionsweise Füllstoff und gegebenenfalls weitere Additive eingetragen, und dann wird unter Rühren - bei Temperaturen bis 100°C - mindestens 1 h entgast. Anschließeno wird der Reaktionsbeschleuniger eindosiert und die Reaktionsharzmischung unter Rühren entgast. Dann wird die Temperatur des Mischbehälters auf 160 bis 180°C eingestellt. Die Reaktion zur prepolymeren Epoxidharzmischung startet in der Regel bei einer Temperatur in der Harzmischung von 130°C, In Abhängigkeit vom chemischen Aufbau von Polyepoxid- und Polyisocyanatharz sowie vom Molverhältnis und je nach Beschleunigerart und -konzentration kann die Reaktionstemperatur kurzzeitig bis 200°C ansteigen.

Die temperatur- und zeitkontrollierte Reaktion wird abgebrochen, wenn die prepolymere Epoxidharzmischung vorliegt. Der Abbruch erfolgt durch Abkühlen der prepolymeren Epoxidharzmischung auf Temperaturen unter 50°C, In Vorversuchen wird der Umsatz der Epoxidgruppen festgelegt, der - abhängig vom Molverhältnis der eingesetzten Epoxid- und Isocyanatgruppen - zum Zeitpunkt des Reaktionsabbruches vorliegen soll. Wichtige Kriterien für den Abbruch der Polymerisationsreaktion sind der Aufschmelzbereich und die Viskosität der prepolymeren Epoxidharzmischung. IR-spektroskopisch wird nachgewiesen, daß in der prepolymeren Epoxidharzmischung keine Isocyanatgruppen mehr vorhanden sind.

Die bei der vorstehend beschriebenen Reaktion erhaltene isocyanatgruppenfreie, latent reaktive prepolymere Epoxidharzmischung wird noch pulverisiert, was in der Weise erfolgen kann, daß bei Raumtemperatur mit einer Feinprallmühle gemahlen wird. Die pulverförmige Epoxidharzmischung wird dann unter Ausschluß von Feuchtigkeit gelagert.

Bei einer zweiten Variante werden Polyepoxid- und Polyisocyanatharz - zur Herstellung einer Harzkomponente - in einem thermostatisierbaren und evakuierbaren Mischbehälter, der beispielsweise mit einem Wendelrührer ausgerüstet ist und eine kontinuierliche Temperaturmessung in der Harzmischung erlaubt, bei Temperaturen bis 100°C unter Rühren gemischt. In diese Harzmischung werden Füllstoff und gegebenenfalls Additive eingemischt, und dann wird unter Rühren bei einer Temperatur bis 100°C mindestens 1 h entgast. In einem zweiten Mischbehälter wird - zur Herstellung einer Beschleunigerkomponente - der Reaktionsbeschleuniger in einer der in der Rezeptur vorgesehenen Harzkomponenten oder in einer Teilmenge davon unter Entgasen gelöst bzw. dispergiert. Die beiden Komponenten werden dann mittels Dosierpumpen, beispielsweise mittels einer beheizbaren Schlauchpumpe bzw. einer Zahnradpumpe, einem statischen Mischrohr zugeführt, und die aus dem Mischrohr austretende Reaktionsharzmischung wird in einen kontinuierlich arbeitenden Reaktor eindosiert.

Als Reaktor eignet sich insbesondere ein Doppelschneckenextruder. Von Vorteil ist dabei, wenn beim Extruder das Verhältnis der Schneckenlänge zum äußeren Schneckendurchmesser 20 bis 50 und insbesondere 25 bis 40 beträgt. Darüber hinaus wird der Extruder vorzugsweise so ausgelegt, daß die Masseverweilzeit bei Schneckendrehzahlen > 10 min⁻¹ kleiner als 5 min ist, vorzugsweise kleiner als 3 min, und eine minimale axiale Rückströmung entsteht.

uer Extruder, dem Harzmengen von 20 bis 200 g/min kontinuierlich zugeführt werden, enthält förderaktive Schneckenelemente (Schneckendurchmesser beispielsweise 31,8 mm, Schneckenlänge 880 mm) und ist mit fünf thermostatisierbaren Zylinderzonen ausgestattet, die beispielsweise auf 160 bis 180°C aufgeheizt werden; die Schneckendrehzahl beträgt 15 bis 30 min. Damit ergibt sich für die Umsetzung der Reaktionsharzmischung in die prepolymere Epoxidharzmischung eine Verweilzeit im Reaktor von weniger als 3 min. Das durch eine Breitschlitzdüse austretende Extrudat wird auf eine gekühlte Abgleitschiene geführt und rasch auf Temperaturen unter 50°C abgekühlt, wobei die Epoxidharzmischung zu bandförmigen Endlosstreifen erstarrt. Diese Streifen werden auf einem Abzugsband unter eine Gegenrolle gezogen und dadurch grob zerkleinert. Das vorzerkleinerte Produkt wird in einer Feinprallmühle auf die gewünschte Korngröße gemahlen. Die auf diese Weise hergestellte rieselfähige, lagerstabile, lösliche bzw. schmelzbare, latent reaktive prepolymere Epoxidharzmischung wird unter Ausschluß von Feuchtigkeit gelagert.

Bei einer dritten Variante erfolgt die Aufbereitung der Harzkomponente wie im zweiten Fall. Zur Herstellung der Beschleunigerkomponente wird der Reaktionsbeschleuniger mit einer Teilmenge des in der Rezeptur vorgesehenen Füllstoffes intensiv gemischt. Die beiden Komponenten werden dann beispielsweise mittels einer Schlauchpumpe bzw. eines Doppelschneckenpulverdosiergerätes in einen Doppelschneckenextruder eindosiert. Im Unterschied zur zweiten Variante sind hierbei die Schnecken in der Mischzone des Extruders, die sich dem Einzugsbereich anschließt, mit förderaktiven Knetelementen versehen; die Temperatur in der Mischzone beträgt bis zu 100°C. Der weitere Aufbau des Extruders und die Verfahrensbedingungen entsprechen weitgehend Variante 2.

Bei einer vierten Variante wird zunächt ein lagerstabiles, rieselfähiges, unlösliches isocyanatgruppenfreies Reaktionsharzpulver hergestellt. Dieses Reaktionsharzpulver wird dann mit Hilfe eines kontinuierlich arbeitenden Reaktors zur prepolymeren Epoxidharzmischung umgesetzt. Zur Herstellung des Reaktionsharzpulvers wird eine beschleunigerhaltige Reaktionsharzmischung in einem Mischbehälter wie im ersten Fall aufbereitet. Dann wird die Temperatur des Mischbehälters auf 160 bis 180°C eingestellt. Die Umsetzung der Reaktionsharzmischung zum unlöslichen isocyanatgruppenfreien Reaktionsharzpulver erfolgt in der Regel ab Reaktionstemperaturen von 130°C innerhalb weniger Minuten, wobei im Mischbehälter durch Rühren ein rieselfähiges Produkt entsteht. Zum Abbruch der Reaktion wird die Temperatur des Mischbehälters mittels eines Kühlthermostaten rasch abgesenkt und das Reaktionsharzpulver unter Rühren unter Temperaturen von 50°C gebracht. In Vorversuchen wird der Umsatz der Epoxidgruppen festgelegt, der zum Zeitpunkt des Reaktionsabbruches vorliegen soll. IR-spektroskopisch wird nachgewiesen, daß im Reaktionsharzpulver keine Isocyanatgruppen mehr vorhanden sind. Das auf diese Weise erhaltene unlösliche isocyanatgruppenfreie Reaktionsharzpulver kann je nach Bedarf über längere Zeit zwischengelagert und dann unter vergleichbaren Bedingungen wie im zweiten Fall in einem kontinuierlich arbeitenden Reaktor zur prepolymeren Epoxidharzmischung umgesetzt werden.

Beim erfindungsgemäßen Verfahren wird die prepolymere Epoxidharzmischung mit einer Füllstoff enthaltenden pulverförmigen Phenolharzmischung gehärtet. Zur Herstellung dieser Phenolharzmischung ist beispielsweise der vorstehend beschriebene Mischbehälter gut geeignet. Dabei wird ein Phenolharz oder ein Gemisch von Phenolharzen aufgeschmolzen und unter Rühren auf Temperaturen bis zu 160°C erwärmt. Anschließend wird in das Phenolharz der Füllstcff portionsweise eingemischt und die Mischung unter Rühren entgast. Nachfolgend wird die Phenolharzmischung auf Raumtemperatur abgekühlt, mit einer Feinprallmühle gemahlen und bei Raumtemperatur unter Ausschluß von Feuchtigkeit gelagert.

Zur Herstellung der flammwidrig eingestellten, rieselfähigen, latent reaktiven, phenolisch härtbaren Epoxidharzformmasse werden die pulverförmige prepolymere Epoxidharzmischung und die pulverförmige Phenolharzmischung im Molverhältnis der phenolischen Hydroxylgruppen zu den Epoxidgruppen von 0,4 bis 1,1 gemischt; vorzugsweise liegt das Molverhältnis bei 0,6 bis 1,0. Gegebenenfalls kann dies unter Zusatz von Additiven erfolgen. Zum Mischen der Komponenten, das bei Raumtemperatur durchgeführt wird, kann beispielsweise ein Kegelstumpfmischer mit Wendelrührer verwendet werden. Das Mischen der Komponenten kann vorteilhaft auch in einem Doppelschneckenextruder erfolgen, der - wie vorstehend beschrieben - neben förderaktiven Schneckenelementen förderaktive Knetelemente aufweist, beispielsweise bei Temperaturen von 90 bis 95°C; das Extrudat wird dann abgekühlt und pulverisiert. Die auf die bescnriebene Weise erhaltene rieselfähige Epoxidharzformmasse wird bei Raumtemperatur unter Ausschluß von Feuchtigkeit gelagert.

Die Umhüllung von elektronischen Bauelementen mit der Epoxidharzformmasse nach der Erfindung wird in der Regel wie folgt durchgeführt. Die rieselfähige Epoxidharzformmasse wird bei Raumtemperatur zu Tabletten gepreßt, und die Tabletten werden mit einer Hochfrequenzheizung auf Temperaturen bis zu 100°C erwärmt. Mit der erwärmten Formmasse werden die elektronischen Bauelemente im Transferpreßverfahren bei Formtemperaturen von 170 bis 190°C und einem Druck von 70 bis 200 bar umhüllt, und die Preßmasse wird dann in der Form 60 bis 120 s gehärtet. Anschließend werden die Bauelemente entformt, und gegebenenfalls wird eine Nachhärtung der Umhüllung bei Temperaturen bis zu 200°C durchgeführt. Alternativ zum Tablettieren und Vorwärmen mit Hochfrequenzheizung kann die pulverförmige Epoxidharzformmasse in einem Plastifiziergerät bei Temperaturen bis zu 100°C verdichtet werden. Unter den gleichen Temperatur- und Preßbedingungen wie bei der Umhüllung von Bauelementen erfolgt im übrigen auch die Herstellung von Prüfkörpern, wie Platten und Stäbe, zur Bestimmung von Formstoffeigenschaften der phenolisch gehärteten Epoxidharzformmasse.

Beim erfindungsgemäßen Verfahren gelangt eine Reaktionsharzmischung von Polyepoxid- und Polyisocyanatharz zum Einsatz, wobei das Polyepoxidharz eine Mischung von di- und mehrfunktionellen Epoxidharzen ist. Dabei beträgt das Molverhältnis von mehrfunktionellem zu difunktionellem Epoxidharz, bezogen auf die Epoxidgruppen, 0,1 bis 1,7 und vorzugsweise 0,2 bis 0,75. Das Molverhältnis der Epoxid- zu den Isocyanatgruppen (in der Reaktionsharzmischung) ist > 1 und beträgt vorzugsweise 1,5 bis 4,0.

Als Epoxidharze, die Bestandteil der Polyepoxidharzmischung sind, eignen sich beim erfindungsgemäßen Verfahren insbesondere Bisphenol A- und Bisphenol F-Epoxidharze sowie Phenolnovolak- und Kresolnovolak-Epoxidharze bzw. Siliconepoxidharze, Triglycidylisocyanurat, Tetraglycidyldiaminodiphenylmethan und Polyglycidylphosphorharze. Als Siliconepoxidharze dienen insbesondere Verbindungen folgender Struktur: 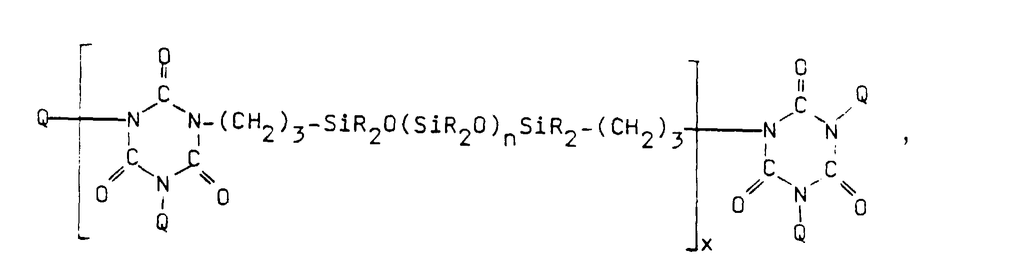 wobei folgendes gilt:
n ist eine ganze Zahl von 0 bis 25,
x ist eine ganze Zahl von 0 bis 3,
R = Alkyl oder Aryl,
Q = -(CH₂)₃SiR₂O(SiR₂O)ₙSiR₂R',
   wobei n und R die vorstehend angegebene Bedeutung haben und R' ein epoxyfunktioneller Rest mit 6 C-Atomen ist.

Der Gehalt an Siliconepoxidharz beträgt bis zu 20 %, vorzugsweise 1 bis 7 %, jeweils bezogen auf die füllstofffreie Reaktionsharzmischung aus Polyepoxid- und Polyisocyanatharz.

Als Polyisocyanatharz werden vorzugsweise Isomerengemische von Diisocyanatodiphenylmethan eingesetzt. Geeignet sind beispielsweise aber auch Isomerengemische von Toluylendiisocyanat und Prepolymere von Isomerengemischen des Diisocyanatodiphenylmethans. Ferner können Mischungen der genannten Polyisocyanatharze verwendet werden.

Als Reaktionsbeschleuniger finden beim erfindungsgemäßen Verfahren substituierte Imidazole Verwendung. Dabei gelangen vorzugsweise 2-Ethyl-4-methylimidazol, 2-Phenylimidazol und 1-Cyanoethyl-2-phenylimidazol zum Einsatz. Weitere geeignete Reaktionsbeschleuniger sind beispielsweise 1,2-Dimethylimidazol, 1-Cyanoethyl-2-methylimidazol, 2-Isopropylimidazol und 1-Benzyl-2-phenylimidazol. Der Gehalt an Reaktionsbeschleuniger beträgt, bezogen auf Polyepoxidharz, d.h. auf die Mischung der di- und mehrfunktionellen Epoxidharze, 0,5 bis 2,5 %, vorzugsweise 1,0 bis 1,8 %.

Als Phenolharz eignen sich insbesondere Phenol- und Kresolnovolakharze, einzeln oder in Mischungen. Die Phenolharzmischungen können auch Prepolymere von Novolakharzen und Siliconelastomer (siliconmodifizierte Phenolharze) enthalten oder Mischungen von Phenolharzen und Phosphinoxiden sein.

Als Füllstoff eignen sich insbesondere mineralische Füllstoffe, wie Quarzgut in splittriger und/oder sphärischer Kornform (unterschiedlicher Korngrößenverteilung), vorzugsweise mit einer Korngröße ≤ 100 µm. Des weiteren können keramische Füllstoffe, wie Aluminiumoxid, sowie Mischungen von keramischen Füllstoffen und mineralischen Füllstoffen verwendet werden. Geeignet sind auch faserförmige Füllstoffe, wie Kurzglasfasern.

Zur Minderung des Werkzeugverschleißes bei der Herstellung und des Formenverschleißes bei der Verarbeitung sowie zur Verbesserung der Entformungseigenschaften können der Epoxidharzformmasse - in geringen Mengen - Additive zugesetzt werden. Dafür eignen sich vorzugsweise das chemisch einbaubare Glycerinmonostearat sowie wachse, wie Carnaubawachs, mikronisiertes Polyethylen, Polyamid und Polytetrafluorethylen. Die Additive werden der Reaktionsharzmischung aus Polyepoxid- und Polyisocyanatharz (bei der Herstellung der prepolymeren Epoxidharzmischung) und/oder der Phenolharzmischung zugesetzt oder - wie mikronisierte Thermoplaste - beim Mischen der prepolymeren Epoxidharzmischung mit der Phenolharzmischung beigemengt. Zur Verschleißminderung kann ferner auch sphärischer Quarzgutfüllstoff dienen.

Ein Verfahren zur Herstellung der flammwidrig eingestellten Epoxidharzformmassen nach der Erfindung ist bislang nicht beschrieben. Bekannt ist jedoch, daß Formmassen aus Polyepoxidharzen und Polyisocyanatharzen unter Verwendung von Reaktionsbeschleunigern gehärtet werden können. Die Formmassen werden dazu beispielsweise bei Temperaturen von 80°C auf einem Walzenstuhl gemischt und bei Temperaturen bis zu 180°C direkt zu Formstoffen gehärtet (siehe dazu: JP-OS 50-059499 und JP-OS 51-128400).

Ferner sind thermisch selbsthärtende Gießharzmischungen aus Polyepoxidharzen und Polyisocyanatharzen bekannt (siehe dazu: EP-PS 0 129 787 und EP-PS 0 130 454). Auch hierbei ist es das Ziel, aus den Reaktionsharzmischungen von Polyepoxidharz und Polyisocyanatharz direkt den gehärteten Formstoff herzustellen.

Im ersten Fall (EP-PS 0 129 787), einem Verfahren zur Herstellung von Formstoffen für Isolierbauteile aus schnellhärtenden, spritzgußanalog verarbeitbaren Reaktionsharzen, werden dazu flüssige Gemische (mit einer Viskosität bis zu 7000 mPa.s bei 25°C) aus im wesentlichen oxazolidinonfreien Polyepoxiden und aus Polyisocyanaten (EP/IC-Harze) - in einem Ansatzmolverhältnis der Epoxidgruppen zu den Isocyanatgruppen von 1 bis 5 - mittels tert. Aminen oder Imidazolen als Härtungskatalysatoren bei Geliertemperaturen von > 130 bis 150°C unter einem Druck zwischen 1 und 10 bar vernetzt und bei Temperaturen von 150 bis 200°C nachgehärtet (unter Bildung von Oxazolidinon- und Isocyanuratringe enthaltenden Reaktionsharzformstoffen, sogenannte OX/ICR-Formstoffe), wobei die Reaktionsbedingungen derart gewählt werden, daß mehr als 90 % der Epoxid- und Isocyanatgruppen umgesetzt sind und daß das Molverhältnis der Oxazolidinon- und Isocyanuratringe (OX:ICR) im Formstoff über 1 liegt.

Im zweiten Fall (EP-PS 0 130 454), einem Verfahren zur Herstellung von Oxazolidinon- (OX) und Isocyanuratringe (ICR) enthaltenden Reaktionsharzformstoffen (OX/ICR-Formstoffe), bei dem Mischungen aus im wesentlichen OX-freien Polyepoxiden und aus Polyisocyanaten (EP/IC-Harze) in Gegenwart eines Härtungskatalysators bei Temperaturen bis 130°C geliert und anschließend nachgehärtet werden, bis mehr als 90 % der Epoxid- und Isocyanatgruppen umgesetzt sind, werden lösungsmittelfreie, flüssige Gemische aus Polyepoxiden und Polyisocyanaten (mit einer Viskosität bis zu 7000 mPa.s bei 25°C) in einem Ansatzmolverhältnis der Epoxid- und Isocyanatgruppen von 1 bis 5 eingesetzt, als Katalysatoren tert. Amine oder Imidazole verwendet und die Reaktionsbedingungen derart gewählt, daß das Molverhältnis der Oxazolidinon- und Isocyanuratringe (OX:ICR) im Formstoff zwischen 1 und 5,7 liegt, d.h. > 1 ist.

Das Verfahren nach der Erfindung unterscheidet sich von den vorstehend beschriebenen Verfahren sowohl in der Zielsetzung als auch in der Verfahrensweise. Dabei sollen nämlich nicht gehärtete Formstoffe hergestellt werden, sondern schmelzbare, latent reaktive prepolymere Epoxidharzmischungen, die mit Phenolharzmischungen - unter Formgebung im Transferpreßverfahren - zu flammwidrigen Formstoffen gehärtet werden und - ohne die Verwendung von halogenhaltigen Flammschutzmitteln und Antimontrioxid - die Forderungen der Elektronik an das Brennverhalten nach UL 94 V-O bei einer Schichtstärke von 1,6 mm erfüllen.

Aus der WO 90/15089 ist es bekannt, epoxyterminierte Polyoxazolidinone (dort vereinfacht als Polyoxazolidone bezeichnet) durch Umsetzung einer Polyepoxidverbindung mit einer Polyisocyanatverbindung bei erhöhter Temperatur in Gegenwart eines Katalysators herzustellen. Dazu werden 5 bis 30 Gew.-% der Polyisocyanatverbindung innerhalb von 30 bis 90 min zu einem Gemisch von 70 bis 95 Gew.-% der Polyepoxidverbindung und 0,01 bis 2 Gew.-% des Katalysators gegeben, und das dabei erhaltene Reaktionsgemisch wird dann für die Dauer von 5 bis 180 min auf eine Temperatur von 110 bis 200°C erhitzt. Das Verfahren wird - durch Regulierung verschiedener Prozeßparameter - in der Weise durchgeführt, daß beim resultierenden epoxyterminierten Polyoxazolidinon, das auch als isocyanatmodifiziertes Epoxidharz bezeichnet wird, 50 bis 100 % der ursprünglichen Isocyanatgruppen in Oxazolidinonringe umgewandelt sind und 0 bis 50 % in Isocyanuratringe.

Als Polyepoxidverbindung dient beim bekannten Verfahren insbesondere Bisphenol A und Tetrabrombisphenol A, die Polyisocyanatverbindung ist 4,4'-Methylen-bis(phenylisocyanat) (MDI) oder ein Isomeres davon, polymeres MDI oder Toluylendiisocyanat. Als Katalysator (für die Reaktion zwischen der Polyepoxid- und der Polyisocyanatverbindung) eignet sich vor allem eine Imidazolverbindung oder Tetraphenylphosphoniumbromid; die Katalysatorkonzentration beträgt vorzugsweise 0,02 bis 1 Gew.-%, insbesondere 0,02 bis 0,1 Gew.-%, bezogen auf das Gesamtgewicht von Polyepoxid- und Polyisocyanatverbindung.

Zur Herstellung der Polyoxazolidinone wird in der Weise vorgegangen, daß der Katalysator, gegebenenfalls gelöst in einem geeigneten Lösungsmittel, der Polyepoxidverbindung zugesetzt wird, im allgemeinen bei einer Temperatur unterhalb der Reaktionstemperatur von 110 bis 200°C. Die Temperatur wird dann auf die Reaktionstemperatur angehoben und dort gehalten, während die Polyisocyanatverbindung kontrolliert zugegeben, d.h. zugetropft wird.

In ähnlicher Weise wird bei einem aus der EP 0 296 450 A1 bekannten Verfahren zur Herstellung von Oxazolidinongruppen enthaltenden (dort vereinfacht als Oxazolidongruppen bezeichnet) oligomeren Polyepoxiden aus Bisepoxiden und Diisocyanaten vorgegangen. Bei diesem Verfahren werden - bei 140 bis 180°C in Gegenwart eines Phosphoniumsalzes als Katalysator - entweder Bisepoxidether mit OH-Gruppen entsprechend einer OH-Zahl von mindestens 2 mit aromatischen Diisocyanaten, welche zwei unterschiedlich reaktive NCO-Gruppen in einer Menge von mindestens 1/4 des Gewichts des Diisocyanats aufweisen, oder Bisepoxidester mit OH-Gruppen entsprechend einer OH-Zahl von mindestens 2 mit aromatischen, aliphatischen oder cycloaliphatischen Diisocyanaten in einem Mengenverhältnis von NCO-Gruppen zu Epoxidgruppen von 1:1,4 bis 1:2,5 umgesetzt. Der Katalysator wird dabei in einer Menge von 0,005 bis 1,0 Gew.-% eingesetzt, bevorzugt 0,01 bis 0,5 Gew.-%, bezogen auf Bisepoxid.

Wesentlich ist bei diesem Verfahren, daß die Oxazolidinon-Epoxidharze nur dann erhalten werden, wenn OH-gruppenhaltige Epoxidharze zusammen mit ungleich reaktive NCO-Gruppen enthaltenden Diisocyanaten - unter Phosphoniumsalzkatalyse - bei ca. 160°C zur Reaktion gebracht werden. Zur Herstellung der Polyepoxide wird dabei in der Weise vorgegangen, daß das Bisepoxidharz zusammen mit dem Katalysator unter Stickstoff auf 160°C aufgeheizt wird. Zu der Schmelze wird dann das Diisocyanat zugetropft, und zwar so schnell, daß eine Temperatur von ca. 170°C eingehalten wird. Nach der Zugabe des gesamten Diisocyanats wird bei 160°C nachgerührt, bis der berechnete Epoxidwert erreicht und kein reaktives NCO mehr nachweisbar ist.

Die in den beiden genannten Druckschriften beschriebene Herstellung von epoxyterminierten Polyoxazolidinonen bzw. von Oxazolidinongruppen enthaltenden Polyepoxiden unterscheidet sich sowohl in der Vorgehensweise bei der Aufbereitung der beschleunigerhaltigen Reaktionsharzmischung (aus Polyepoxidharzen und Polyisocyanatharzen) als auch in der Zusammensetzung der Reaktionsharzmischung grundsätzlich vom erfindungsgemäßen Verfahren zur Herstellung einer latent reaktiven prepolymeren Epoxidharzmischung. So werden beim Stand der Technik, wie insbesondere aus den Ausführungsbeispielen hervorgeht, geringe Katalysatorkonzentrationen verwendet, nämlich 0,01 bis 0,35 % (WO 90/15089) bzw. 0,1 % (EP 0 296 450 A1), jeweils bezogen auf Polyepoxid. Zur Herstellung der reaktiven, härtbaren prepolymeren Epoxidharzmischung werden jedoch wesentlich höhere Katalysatormengen benötigt. Beim erfindungsgemäßen Verfahren beträgt die Katalysatorkonzentration deshalb 0,5 bis 2,5 %, bevorzugt 1,0 bis 1,8 %, bezogen auf die Mischung der di- und mehrfunktionellen Epoxidharze. Diese hohen Katalysatorkonzentrationen sind erforderlich, damit die latent reaktive prepolymere Epoxidharzmischung ohne eine - bei füllstoffhaltigen Systemen aufwendige - Nachbeschleunigung in einer technisch relevanten Zeit gehärtet werden kann.

Die Verwendung derart hoher Katalysatormengen ist aber nur möglich, wenn nach dem erfindungsgemäßen Verfahren vorgegangen wird, wobei eine komplette Reaktionsharzmischung, bestehend aus einer Mischung von di- und mehrfunktionellen Epoxidharzen, Polyisocyanatharz und Füllstoff, unter Verwendung von Imidazolen der genannten Art bei Temperaturen bis zu 100°C aufbereitet und mit dieser Mischung bei Reaktionstemperaturen bis 200°C die latent reaktive prepolymere Epoxidharzmischung hergestellt wird. Es hat sich aber gezeigt, daß es bei einer derart hohen Katalysatorkonzentration nicht möglich ist, die Epoxidharzmischung nach der Erfindung - entsprechend dem Stand der Technik - auf Temperaturen bis zu 170°C zu erwärmen, den Reaktionsbeschleuniger zuzugeben und das Polyisocyanatharz einzudosieren, da auf diese Weise gelierte bzw. gehärtete Produkte entstehen, aber keine löslichen, aufschmelzbaren, latent reaktiven prepolymeren Epoxidharzmischungen erhalten werden.

Das erfindungsgemäße Verfahren unterscheidet sich auch in der Zusammensetzung der Reaktionsharzmischung (aus Polyepoxidharz und Polyisocyanatharz) grundlegend von den aus dem Stand der Technik (WO 90/15089 bzw. EP 0 296 450 Al) bekannten Reaktionsharzmischungen. Einerseits handelt es sich bei den Reaktionsharzmischungen nach der Erfindung nämlich um hochgefüllte Mischungen, die aufgrund ihrer hohen Viskosität bei Raumtemperatur in der Regel fest sind und für deren Aufbereitung und Handhabung andere Bedingungen erforderlich sind als bei ungefüllten Reaktionsharzmischungen. Andererseits werden zur Herstellung dieser hochgefüllten Reaktionsharzmischungen Mischungen von di- und mehrfunktionellen Epoxidharzen verwendet, beispielsweise aus Bisphenol A-Epoxidharzen mit tetrafunktionellen Epoxidharzen, wie Tetraglycidyldiaminodiphenylmethan und Siliconepoxidharzen. Solche Mischungen sind aber aus dem Stand der Technik nicht bekannt. Darüber hinaus werden dort weder der besonders geeignete Reaktionsbeschleuniger 1-Cyanoethyl-2-phenylimidazol noch die - für die Verarbeitungseigenschaften wichtigen - Siliconepoxidharze und das - zur Anhebung der Glasübergangstemperatur besonders geeignete - Tetraglycidyldiaminodiphenylmethan genannt.

Es war völlig überraschend und für den Fachmann auch nicht vorhersehbar, daß beim erfindungsgemäßen Verfahren bei der Herstellung der prepolymeren Epoxidharzmischung die Verwendung von mehrfunktionellen Epoxidharzen, wie Tetraglycidyldiaminodiphenylmethan und die angeführten Siliconepoxidharze, sowie die Anwendung hoher Beschleunigerkonzentrationen - selbst bei Reaktionstemperaturen bis zu 200°C - nicht zu einer Härtung, d.h. chemischen Vernetzung der Reaktionsharzmischung aus Polyepoxid- und Polyisocyanatharz führt, sondern eine lagerstabile, lösliche bzw. schmelzbare, latent reaktive prepolymere Epoxidharzmischung erhalten wird, die - ohne Nachbeschleunigung - sehr gut gehärtet werden kann.

Es zeigte sich ferner, daß sowohl die prepolymere Epoxidharzmischung als auch die damit hergestellte phenolisch härtbare Epoxidharzformmasse eine hervorragende latent reaktive Einstellung besitzen; außerdem weisen sie, wie später noch gezeigt wird (siehe Tabelle 4), eine sehr gute Lagerstabilität auf. Besonders vorteilhaft ist auch, daß die latent reaktive Einstellung der phenolisch härtbaren Epoxidharzformmasse, im Hinblick auf den Einsatzzweck, über die Konzentration - und auch über die Art - des Reaktionsbeschleunigers (in der Reaktionsharzmischung aus Polyepoxid- und Polyisocyanatharz) gezielt eingestellt werden kann, ohne daß dadurch die Lagerstabilität eingeschränkt wird (siehe dazu auch Tabelle 5). Zur Erhöhung der Reaktivität der Epoxidharzformmasse ist deshalb keine aufwendige Nachbeschleunigung erforderlich. Die latent reaktive Einstellung der phenolisch härtbaren Epoxidharzformmasse kann zusätzlich noch über das Molverhältnis der phenolischen Hydroxylgruppen zu den Epoxidgruppen variiert werden (siehe Tabelle 6).

Eine Möglichkeit zur Einstellung der Reaktivität der phenolisch härtbaren Epoxidharzformmasse besteht auch in der Verwendung einer einen Reaktionsbeschleuniger enthaltenden Phenolharzmischung als Härterkomponente. Damit kann eine sehr schnell härtende Epoxidharzformmasse hergestellt werden, ohne daß dadurch die Lagerstabilität beeinträchtigt wird. Als ein derartiger Reaktionsbeschleuniger dient vorzugsweise ein substituiertes Imidazol, wie 1-Cyanoethyl-2-phenylimidazol und 2-Phenylimidazol, oder Triphenylphosphin. Der Gehalt des Reaktionsbeschleunigers in der Phenolharzmischung beträgt 0,5 bis 1,5 %, vorzugsweise 0,8 bis 1,2 %, bezogen auf das Phenolharz.

Die Brennbarkeitsprüfung nach UL 94 zeigt, daß die aus der erfindungsgemäßen Epoxidharzformmasse hergestellten Formstoffe die von der Elektronik geforderte Einstufung V-O bei einer Schichtstärke ≤ 1,6 mm erreichen. Dies ist überraschend, weil auf der Basis von Kresolnovolak-Epoxidharzen und Phenolharzen (als Härter) hergestellte Epoxidharzformstoffe, die den Füllstoff Quarzgut in der gleichen Konzentration enthalten wie die Epoxidharzformmasse nach der Erfindung, ohne Verwendung von bromierten Flammschutzmitteln und Antimontrioxid keine Einstufung nach UL 94 V-O bei 1,6 mm Schichtstärke erreichen, die Prüfkörper vielmehr vollständig abbrennen.

Als besonders vorteilhaft erweist sich beim erfindungsgemäßen Verfahren die Verwendung von Siliconepoxidharzen, und zwar sowohl für die Herstellung und Verarbeitung der phenolisch härtbaren Epoxidharzformmasse als auch für die Formstoffeigenschaften. So wird bei der Herstellung der prepolymeren Epoxidharzmischung ein schonendes Mahlen beim Pulverisieren ermöglicht, und bei der Verarbeitung der Epoxidharzformmasse werden das Fließverhalten bei der Formgebung und die Entformungseigenschaften der umhüllten elektronischen Bauelemente verbessert. Beispielsweise wird die Spiralfließlänge, die ein Maß für die Fließfähigkeit von Transferpreßmassen unter Druck und Temperatur darstellt, durch den Einsatz der Siliconepoxidharze deutlich verbessert und bis zu 20 % verlängert. Über den chemischen Aufbau und den Gehalt der Siliconepoxidharze können ferner die Haftungseigenschaften der phenolisch härtbaren Epoxidharzformmasse an unterschiedliche Substrate angepaßt weraen. Dies ist von besonderer Bedeutung für die Haftung auf den aus Legierungen bestehenden Systemträgern (leadframes) der elektronischen Bauelemente. Bei der Brennbarkeitsprüfung der Epoxidharzformstoffe nach UL 94 zeigt sich, daß bereits geringe Zusätze von Siliconepoxidharz das flammwidrige Verhalten verbessern.

Epoxidharzformstoffe, die sich für die Abdeckung und Umhüllung von elektronischen Bauelementen eignen sollen, müssen ausgezeichnete mechanisch-thermische Eigenschaften besitzen und dürfen auch bei extremen Prüfbedingungen, wie der Temperaturwechselbelastung mit 1000 Temperaturzyklen von -65 bis +150°C, keine mechanisch-thermische Beanspruchung (Streß) verursachen, die zum Ausfall von Bauelementen führt. Das Streßverhalten der Epoxidharzformstoffe wird vor allem von der Glasübergangstemperatur, dem linearen thermischen Ausdehnungskoeffizienten und dem Elastizitätsmodul beeinflußt. Es hat sich gezeigt, daß mit den erfindungsgemäßen Epoxidharzformmassen mechanisch-thermische Formstoffeigenschaften erzielt werden, die den Forderungen für die Umhüllung von elektronischen Bauelementen entsprechen (siehe Tabellen 7 und 8). Von besonderem Vorteil erwies sich dabei, daß zur Herstellung der Epoxidharzmischungen Mischungen aus di- und mehrfunktionellen Epoxidharzen verwendet werden. Mit diesen Mischungen kann nämlich die Glasübergangstemperatur der Epoxidharzformstoffe deutlich angehoben werden, ohne daß der Elastizitätsmodul und der lineare Ausdehnungskoeffizient nachteilig beeinflußt werden. So werden, wie später noch gezeigt wird (siehe Tabelle 7), bei den Epoxidharzformstoffen nach der Erfindung Glasübergangstemperaturen > 150°C erreicht. Werden dagegen ausschließlich difunktionelle Epoxidharze eingesetzt, so ist dies nicht möglich. In diesem Fall werden nämlich lediglich Glasübergangstemperaturen im Bereich von 135 bis 140°C erhalten.

Auch bei einem Vergleich der Verarbeitungsbedingungen der erfindungsgemäßen Epoxidharzformmasse und wesentlicher Formstoffeigenschaften mit einer Formmasse bzw. einem Formstoff nach dem Stand der Technik zeigt sich, daß durch die erfindungsgemäße Epoxidharzformmasse die anspruchsvol-len Forderungen der Elektronik an die Verarbeitungs- und Formstoffeigenschaften erfüllt werden (siehe Tabelle 9). Zum Vergleich diente dabei die weltweit eingesetzte Preßmasse Nitto HC 10/2. Bei dieser Preßmasse handelt es sich um eine phenolisch härtbare Kresolnovolak-Epoxidharzformmasse, die 70 % splittriges Quarzgut als Füllstoff enthält und mit Tetrabrombisphenol A-Epoxidharz sowie Antimontrioxid als Synergist flammwidrig eingestellt ist.

Die Epoxidharzformstoffe nach der Erfindung erfüllen darüber hinaus - aufgrund ihrer umweltgerechten Eigenschaften - weitere wichtige Forderungen der Elektronik für den zukünftigen Einsatz. Dies betrifft insbesondere die Eignung der Formstoffe für ein umweltschonendes Recycling und eine umweltverträgliche Entsorgung durch Verbrennung. Die im Vergleich zum Stand der Technik verbesserte Umweltverträglichkeit der halogenfrei flammwidrigen Epoxidharzformstoffe ist dadurch belegt, daß - im Gegensatz zu Epoxidharzformstoffen mit bromierten Flammschutzmitteln und Antimontrioxid - bei der Verbrennung keine hochkorrosiven gasförmigen Spaltprodukte und keine Zersetzungsprodukte mit hohem toxikologisch-ökologischen Gefährdungspotential gebildet werden. Bei der Verbrennung, beispielsweise nach der DIN-Methode 53436, werden nur Verbrennungsprodukte gefunden wie sie auch bei Naturprodukten, wie Wolle, Holz und Kohle, auftreten. Damit ist gewährleistet, daß im Störfall, wie Brand oder Verschwelung, keine über den Normalfall hinausgehende Umweltbelastung entsteht und bei der Entsorgung durch Verbrennung wie bei normalem Hausmüll verfahren werden kann.

Die Eignung der aus der erfindungsgemäßen Epoxidharzformmasse hergestellten Formstoffe für ein Recycling ist für die Elektronik von besonderer Bedeutung, weil bei der Umhüllung von Bauelementen nach dem Transferpreßverfahren erhebliche Mengen an Epoxidharzformstoff als Abfall entstehen. Außerdem sollen zukünftig die Epoxidharzformstoffe aus dem Elektronikschrott - nach dem Abtrennen der Metalle - einer weiteren Verwendung zugeführt werden. Für ein Recycling bieten die Epoxidharzformstoffe gute Voraussetzungen, weil sie einerseits mechanisch-thermisch hochbelastbar sind und eine ausgezeichnete chemische Beständigkeit gegenüber aggressiven Chemikalien besitzen und andererseits - im Vergleich zum Stand der Technik - eine wichtige Forderung erfüllen, nämlich umweltgerechte Materialeigenschaften.

Für das Recycling von Werkstoffabfällen beim Transferpressen bietet sich vor allem die Verwendung als Füllstoff an. Die technisch hochwertigen Füllstoffe können in der Elektronik und in der Elektrotechnik generell sowie für andere Technologien, beispielsweise die Fahrzeugtechnik, und die dafür erforderlichen thermoplastischen und duroplastischen Werkstoffe verwendet werden. Sie eignen sich aber auch zur erneuten Verwendung für die Umhüllung von elektronischen Bauelementen; die Werkstoffabfälle werden dazu auf die geforderte Korngröße gemahlen. Mit der Epoxidharzformmasse nach der Erfindung steht somit ein für die Elektronik geeigneter umweltgerechter, halogenfrei flammwidriger Abdeck- und Umhüllwerkstoff zur Verfügung, der gegenüber dem Stand der Technik einen wesentlichen Fortschritt hinsichtlich der Symbiose von Technik und Umwelt darstellt.

Anhand von Ausführungsbeispielen soll die Erfindung noch näher erläutert werden.

### Beispiel 1

### Herstellung einer prepolymeren Epoxidharzmischung

In einen Mischbehälter werden 255 g Bisphenol A-Epoxidharz (Epoxidwert: 5,78 mol/kg), 16,5 g eines Siliconepoxids (Epoxidwert: 1,9 mol/kg), hergestellt nach Beispiel 9 der EP-OS 0 399 199, 82,5 g Tetraglycidyldiaminodiphenylmethan (Epoxidwert: 8,2 mol/kg) und 90 g eines Isomerengemisches von Diisocyanatodiphenylmethan (Isocyanatwert: 7,9 mol/kg) gegeben, dann wird auf 80°C erwärmt und unter Rühren gemischt und entgast. Nachfolgend werden zur Mischung unter Rühren portionsweise 724,5 g sphärisches Quarzgut, 310,5 g splittriges Quarzgut und 15 g Ruß gegeben, anschließend wird 1 h bei 80°C unter Rühren entgast. In die Reaktionsharzmischung werden 5,55 g 1-Cyanoethyl-2-phenylimidazol eindosiert, dann wird 15 min unter Rühren entgast. Nachfolgend wird die Temperatur des Mischbehälters auf 180°C eingestellt und die Reaktionsharzmischung unter Rühren zur Reaktion gebracht. Der Reaktionsverlauf wird durch Temperaturmessung ständig verfolgt. Der Abbruch der Reaktion erfolgt 4 min nach Erreichen der Reaktionstemperatur von 130°C in der Harzmischung. Dazu wird der Mischbehälter mittels eines Kühlthermostaten rasch abgekühlt und die Harzmischung auf eine Temperatur unter 50°C gebracht. Zu diesem Zeitpunkt liegen keine freien Isocyanatgruppen mehr vor, von den eingesetzten Epoxidgruppen sind 40 % umgesetzt. Die beim Abkühlen erstarrende Masse wird durch das Rührwerk des Mischbehälters grob zerkleinert. Diese Masse wird dann bei Raumtemperatur mittels einer Feinprallmühle auf eine Korngröße < 200 µm gemahlen. Die dabei erhaltene rieselfähige, latent reaktive prepolymere Epoxidharzmischung 1 (Epoxidwert: 0,86 mol/kg; Aufschmelzbereich: 75 bis 95°C) wird bei Raumtemperatur unter Feuchteausschluß gelagert.

### Beispiel 2

### Herstellung einer Phenolharzmischung

In einen Mischbehälter werden 900 g Kresolnovolakharz und 30 g Ruß gegeben, und die beiden Komponenten werden unter Rühren auf 160°C erwärmt. Unter weiterem Rühren wird dann 1,5 h entgast. Nachfolgend werden in die 160°C warme Phenolharzmischung 1450 g sphärisches Quarzgut und 620 g splittriges Quarzgut portionsweise eingemischt. Anschließend wird nochmals unter Rühren 1,5 h entgast. Die beim Abkühlen erstarrende Masse wird durch das Rührwerk grob zerkleinert. Diese Masse wird dann bei Raumtemperatur mittels einer Feinprallmühle auf eine Korngröße < 200 µm gemahlen. Die dabei erhaltene rieselfähige Phenolharzmischung 2 (OH-Wert: 2,35 mol/kg) wird bei Raumtemperatur unter Feuchteausschluß gelagert.

### Beispiel 3

### Herstellung einer phenolisch härtbaren Epoxidharzformmasse

1000 g der rieselfähigen prepolymeren Epoxidharzmischung nach Beispiel 1 und 282 g der rieselfähigen Phenolharzmischung nach Beispiel 2 werden bei Raumtemperatur in einem Kegelstumpfmischer mit Wendelrührer intensiv gemischt. Die dabei erhaltene rieselfähige, latent reaktive, phenolisch härtbare Epoxidharzformmasse 3 (Epoxidwert:
0,62 mol/kg; Viskosität: 105 Pa.s bei 162°C; Spiralfließlänge: 67 cm bei 175°C), die flammwidrig eingestellt ist, wird bei Raumtemperatur unter Feuchteausschluß gelagert.

### Beispiele 4 bis 11

Entsprechend Beispiel 1 werden weitere prepolymere Epoxidharzmischungen hergestellt. Die jeweilige Zusammensetzung der Reaktionsharzmischungen, die zur Herstellung der Epoxidharzmischungen 4 bis 11 dienen, sind in Tabelle la aufgeführt (Angaben in Masseteilen). In Tabelle 1b sind - als Kenndaten der prepolymeren Epoxidharzmischungen (4 bis 11) - jeweils der Epoxidwert und der Aufschmelzbereich angegeben.

### Beispiele 12 bis 17

Entsprechend Beispiel 2 werden weitere Phenolharzmischungen hergestellt. Die jeweilige Zusammensetzung der Phenolharzmischungen 12 bis 17 ist in Tabelle 2 aufgeführt (Angaben in Masseteilen).

### Beispiele 18 bis 29

Entsprechend Beispiel 3 werden weitere phenolisch härtbare Epoxidharzformmassen hergestellt. Die jeweilige Zusammensetzung der Epoxidharzformmassen 18 bis 29 ist in Tabelle 3 aufgeführt.

In Tabelle 4 sind für die prepolymere Epoxidharzmischung 1 sowie für die phenolisch härtbaren Epoxidharzformmassen 3 und 19 jeweils der Epoxidwert (EP-Wert) und die Viskosität in Abhängigkeit von der Lagerzeit angegeben.

Tabelle 5 ist - für die phenolisch härtbare Epoxidharzformmasse 19 - der Einfluß von Art und Konzentration des Reaktionsbeschleunigers auf den Viskositätsverlauf zu entnehmen. Die angegebenen Zeiten bis zur Verzehnfachung der Ausgangsviskosität (bei 175°C) verdeutlichen die Variationsbreite bei der latent reaktiven Einstellung der Epoxidharzformmassen nach der Erfindung.

Tabelle 6 ist - für die phenolisch härtbaren Epoxidharzformmassen 3, 19, 20 und 21 - der Einfluß des Molverhältnisses von phenolischen Hydroxylgruppen zu Epoxidgruppen (OH:EP) auf den Viskositätsverlauf zu entnehmen. Wie den angegebenen Zeiten bis zur Verzehnfachung der Ausgangsviskosität (bei 175°C) zu entnehmen ist, kann über das Molverhältnis OH:EP die latent reaktive Einstellung der Epoxidharzformmassen variiert werden.

In Tabelle 7 sind die Bedingungen (Temperatur, Zeit) bei der Härtung bzw. Nachhärtung der Epoxidharzformmassen 3, 18, 19, 22, 24, 25, 26, 28 und 29 sowie die Glasübergangstemperaturen der entsprechenden Formstoffe zusammengefaßt.

In Tabelle 8 sind für die aus den Epoxidharzformmassen 3, 18, 19, 22, 25, 26, 28 und 29 hergestellten Formstoffe - neben den Härtungsbedingungen - der lineare thermische Ausdehnungskoeffizient (α) und der Elastizitätsmodul (E') als weitere Beispiele für die mechanisch-thermischen Eigenschaften angegeben.

Tabelle 9 zeigt die Gegenüberstellung von flammwidrigen EP-Formstoffen, die aus einer handelsüblichen Preßmasse bzw. aus einer Epoxidharzformmasse nach der Erfindung - jeweils durch Transferpressen - hergestellt wurden. Dabei sind einerseits die Verarbeitungsbedingungen der Formmassen und andererseits die Eigenschaften der entsprechenden Formstoffe angegeben. Die handelsübliche Preßmasse ist im übrigen durch den Zusatz von bromierten Flammschutzmitteln und Antimontrioxid flammwidrig eingestellt, während die erfindungsgemäße Epoxidharzformmasse 27 halogenfrei flammwidrig ist.

### Beispiel 30

### Herstellung einer prepolymeren Epoxidharzmischung

In einen thermostatisierbaren und evakuierbaren Mischbehälter (Nutzinhalt: 20 1) werden zur Herstellung einer Harzkomponente 2,55 kg Bisphenol A-Epoxidharz (Epoxidwert: 5,78 mol/kg), 0,155 kg eines Siliconepoxids (Epoxidwert: 1,9 mol/kg), hergestellt nach Beispiel 9 der EP-OS 0 399 199, 0,81 kg Tetraglycidyldiaminodiphenylmethan (Epoxidwert: 8,2 mol/kg) und 0,885 kg eines Isomerengemisches von Diisocyanatodiphenylmethan (Isocyanatwert: 7,9 mol/kg) gegeben; die Mischung wird dann unter Rühren auf 60°C erwärmt. Nachfolgend werden zur Mischung unter Rühren portionsweise 6,195 kg sphärisches Quarzgut, 2,655 kg splittriges Quarzgut, 0,075 kg Polyethylenwachs und 0,135 kg Ruß gegeben. Anschließend wird 1 h bei 60°C unter Rühren entgast. Zur Herstellung einer Beschleunigerkomponente werden 1,05 kg sphärisches Quarzgut, 0,45 kg splittriges Quarzgut, 0,015 kg Ruß und 55,5 g 1-Cyanoethyl-2-phenylimidazol homogen gemischt. Die Harzkomponente und die Beschleunigerkomponente werden gleichzeitig in einen Doppelschneckenextruder eindosiert, die Harzkomponente mittels einer Schlauchpumpe bei einem kontinuierlichen Massefluß von 0,042 kg/min und die Beschleunigerkomponente mittels einer Doppelschneckendosiereinrichtung (Massefluß: 5 g/min). Die Schnecken des Extruders sind aus Förderelementen aufgebaut, und unmittelbar nach der Einzugszone sind zum homogenen Mischen der Harz- und der Beschleunigerkomponente drei fördernde Knetblöcke von je 28 mm Länge montiert. Die Schneckenlänge beträgt 880 mm, der äußere Schneckendurchmesser 31,8 mni; die fünf Zylinderzonen des Extruders sind auf folgende Temperatur eingestellt: Zone 1 (Mischzone): 81°C, Zone 2: 130°C, Zone 3: 177°C, Zone 4: 178°C, Zone 5: 180°C. Die Schneckendrehzahl beträgt 20 min⁻¹, wodurch sich eine Masseverweilzeit im Doppelschneckenextruder von 2,5 min ergibt.

Das durch eine Doppelschlitzdüse (Querschnitt: je 2 mm × 20 mm) austretende Extrudat wird auf eine gekühlte Abgleitschiene geführt, auf 43°C abgekühlt und auf einem angeschlossenen elastischen Abzugsband durch eine Gegenrolle zerkleinert. Das vorzerkleinerte Extrudat wird mittels einer Feinprallmühle auf die gewünschte Korngröße gemahlen. Die dabei erhaltene rieselfähige, latent reaktive, härtbare prepolymere Epoxidharzmischung 30 (Epoxidwert: 0,84 mol/kg; Aufschmelzbereich: 75 bis 95°C) wird bei Raumtemperatur unter Ausschluß von Feuchtigkeit gelagert.

### Beispiel 31

### Herstellung einer prepolymeren Epoxidharzmischung

Entsprechend Beispiel 1 wird eine füllstoffhaltige Reaktionsharzmischung hergestellt. In diese Reaktionsharzmischung werden 5,55 g 1-Cyanoethyl-2-phenylimidazol eindosiert, dann wird 10 min unter Rühren entgast. Nachfolgend wird die Reaktionsharzmischung durch Aufheizen des Mischbehälters auf 160°C unter weiterem Rühren zur Reaktion gebracht; der Reaktionsverlauf wird durch Temperaturmessung ständig vefolgt. Der Abbruch der Reaktion erfolgt 1 min nach dem Festweraen der Reaktionsharzmischung, und zwar durch Abkühlen des Mischbehälters mit einem Kühlthermostaten. Dabei wird die Temperatur der Reaktionsharzmischung - unter weiterem Rühren - auf unter 50°C gebracht. Durch das ständige Rühren fällt das isocyanatgruppenfreie, Isocyanuratstrukturen aufweisende unlösliche Reaktionsprodukt als lagerstabiles, rieselfähiges Pulver an. Dieses Reaktionsharzpulver wird über eine Rüttelrinne mit einem kontinuierlichen Massefluß von 30 g/min einem Doppelschneckenextruder zugeführt. Die Schneckenlänge beträgt 880 mm, der äußere Schneckendurchmesser 31,8 mm; die fünf Zylinderzonen des Extruders sind auf 160°C geheizt. Die Schneckendrehzahl beträgt 90 min⁻¹, wodurch sich eine Masseverweilzeit im Extruder von 1,5 min ergibt.

Das Extrudat wird durch eine Doppelschlitzdüse (Querschnitt: je 2 mm x 20 mm) ausgetragen, durch unmittelbaren Kontakt mit einer gekühlten Abgleitschiene auf 45°C abgekühlt und auf einem angeschlossenen elastischen Abzugsband durch eine Gegenrolle zerkleinert. Die Masse wird dann mittels einer Feinprallmühle auf eine Korngröße < 200 µm gemahlen. Die dabei erhaltene rieselfähige, latent reaktive, härtbare prepolymere Epoxidharzmischung 31 (Epoxidwert: 0,86 mol/kg; Aufschmelzbereich: 75 bis 95°C) wird bei Raumtemperatur unter Ausschluß von Feuchtigkeit gelagert.

### Beispiel 32

### Herstellung einer phenolisch härtbaren Epoxidharzformmasse

Entsprechend Beispiel 3 wird eine phenolisch härtbare Epoxidharzformmasse 32 hergestellt, deren Zusammensetzung in Tabelle 3 aufgeführt ist.

In Tabelle 7 sind die Bedingungen bei der Härtung bzw. Nachhärtung der Epoxidharzformmasse 32 sowie die Glasübergangstemperatur des entsprechenden Formstoffes aufgeführt, in Tabelle 8 - neben den Härtungsbedingungen - der lineare thermische Ausdehnungskoeffizient und der Elastizitätsmodul.

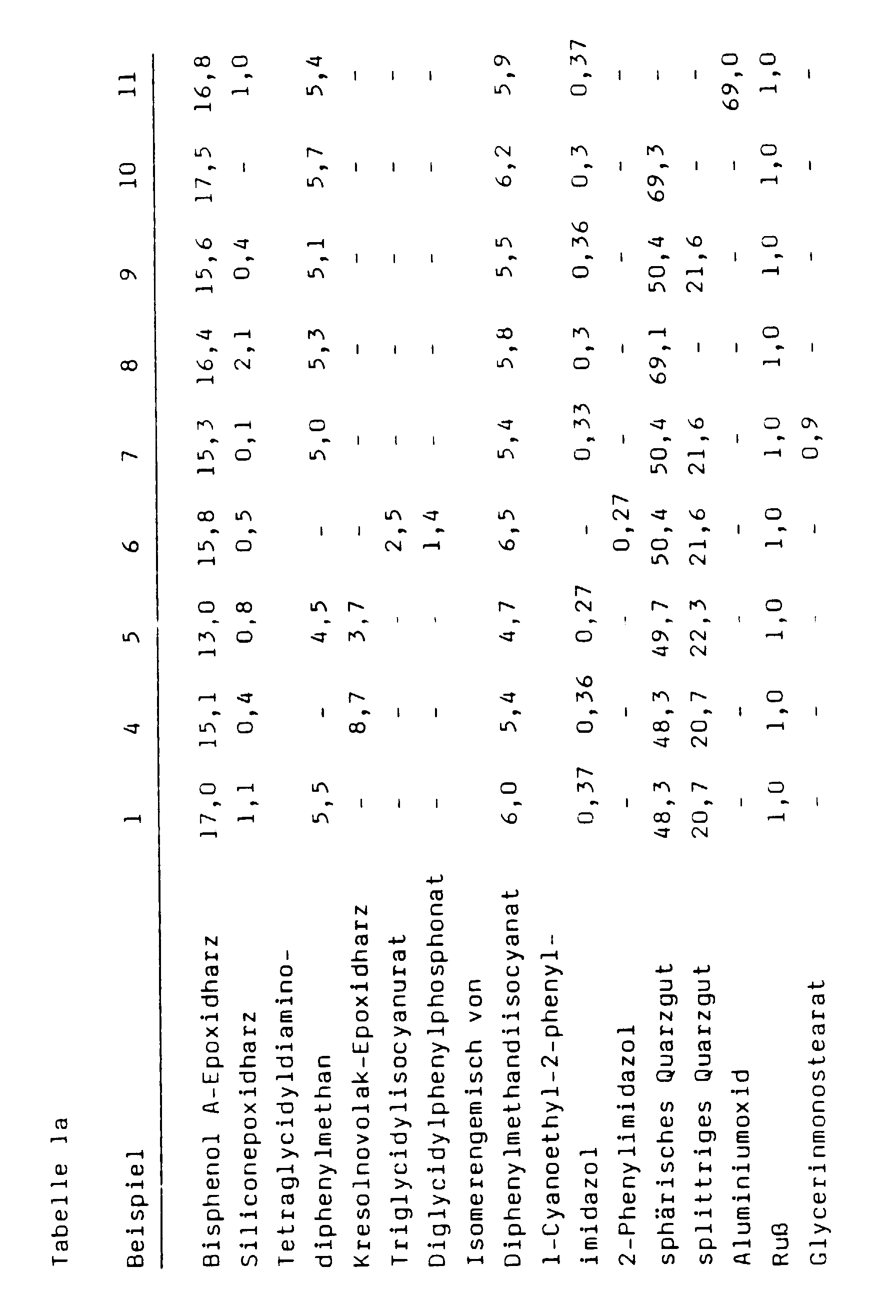

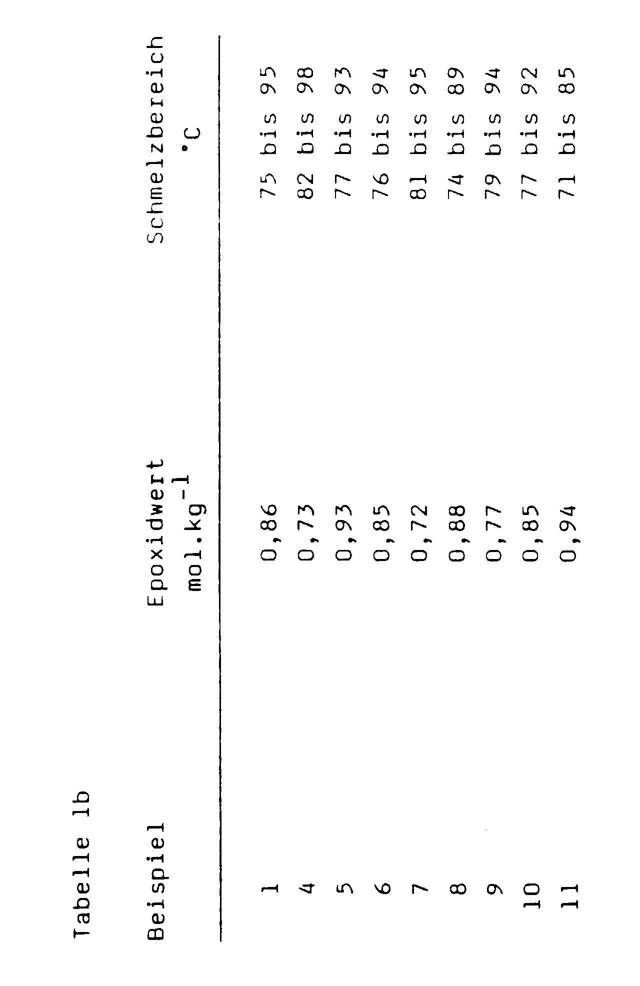

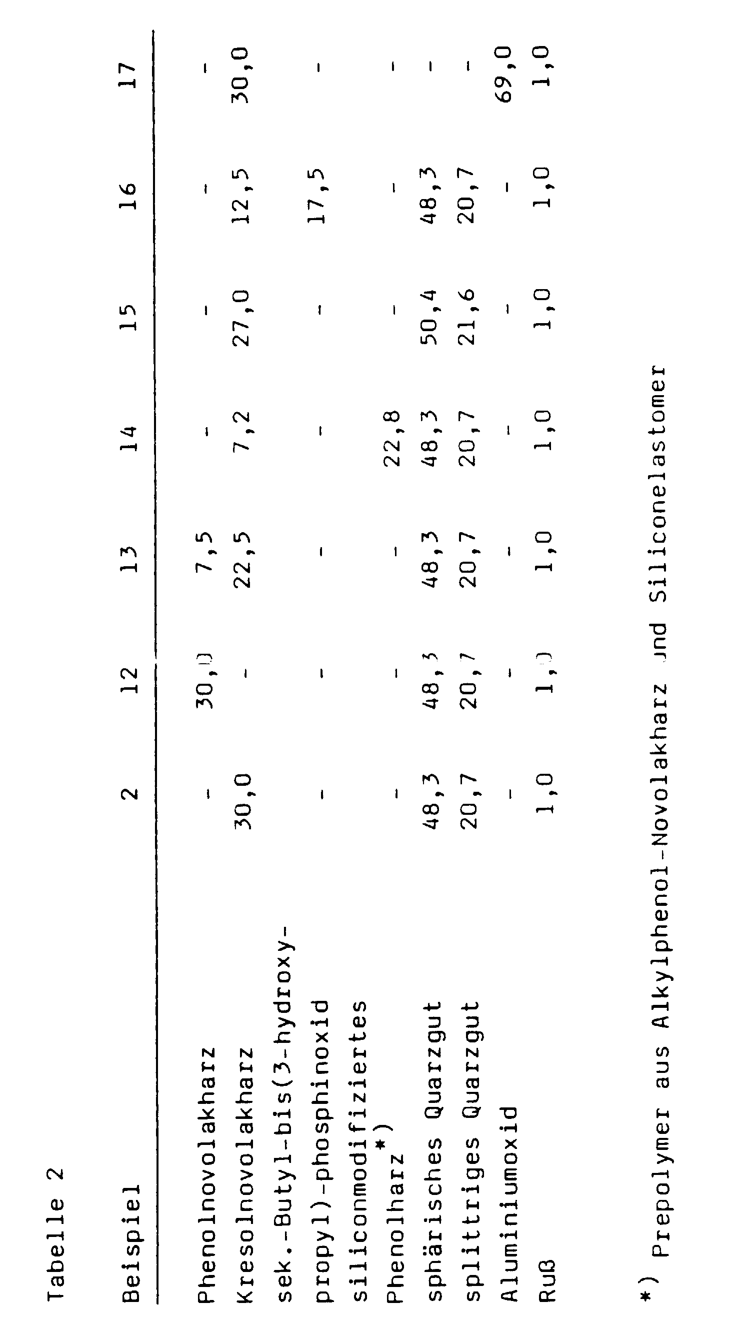

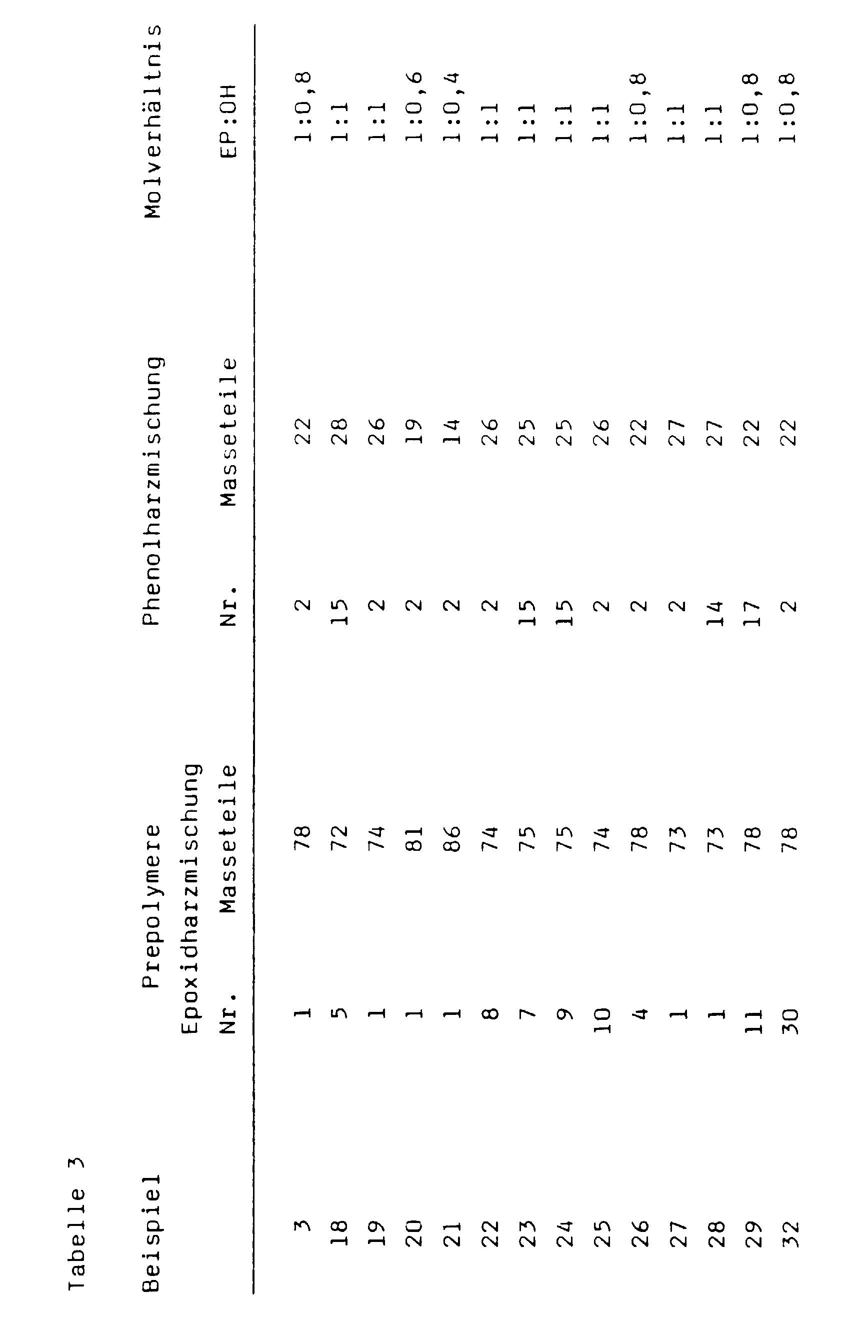

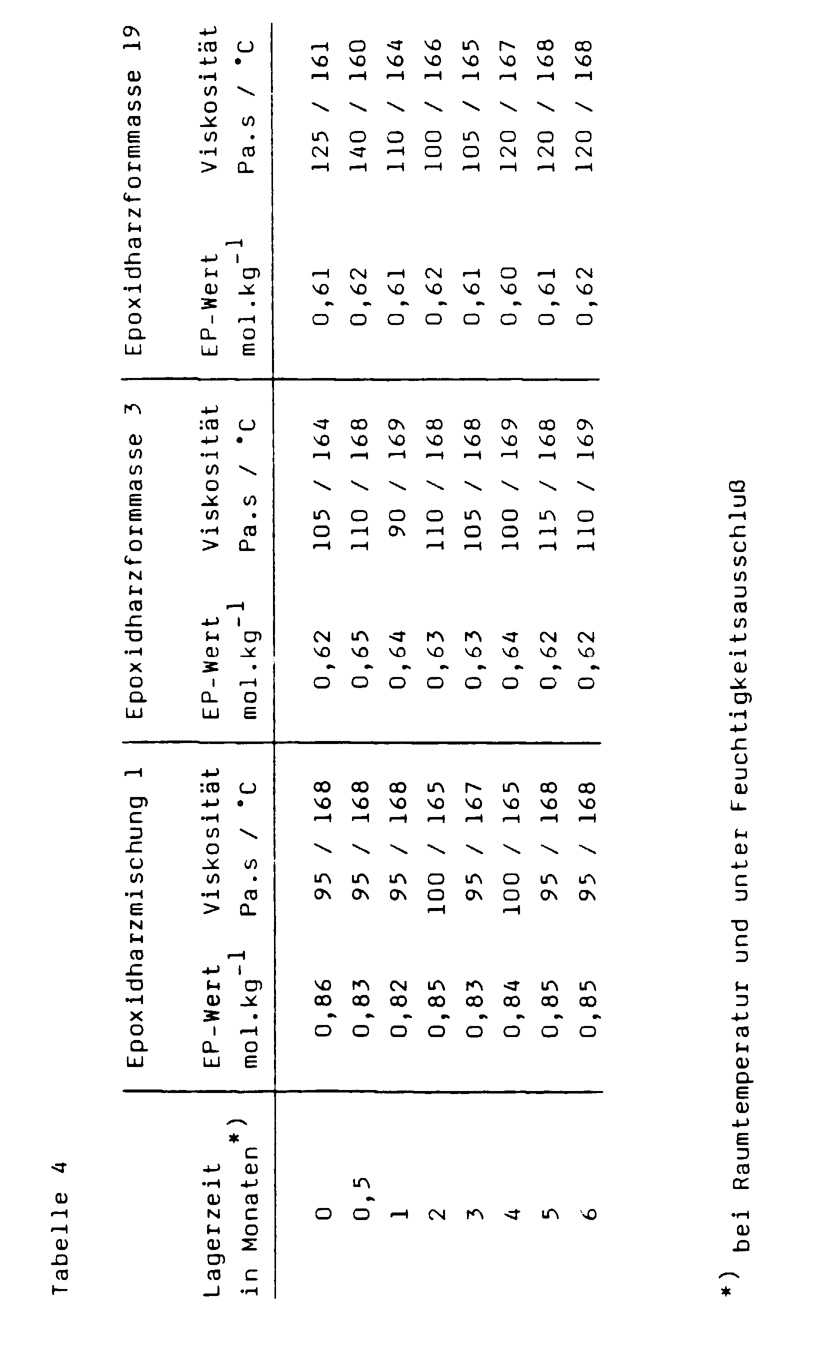

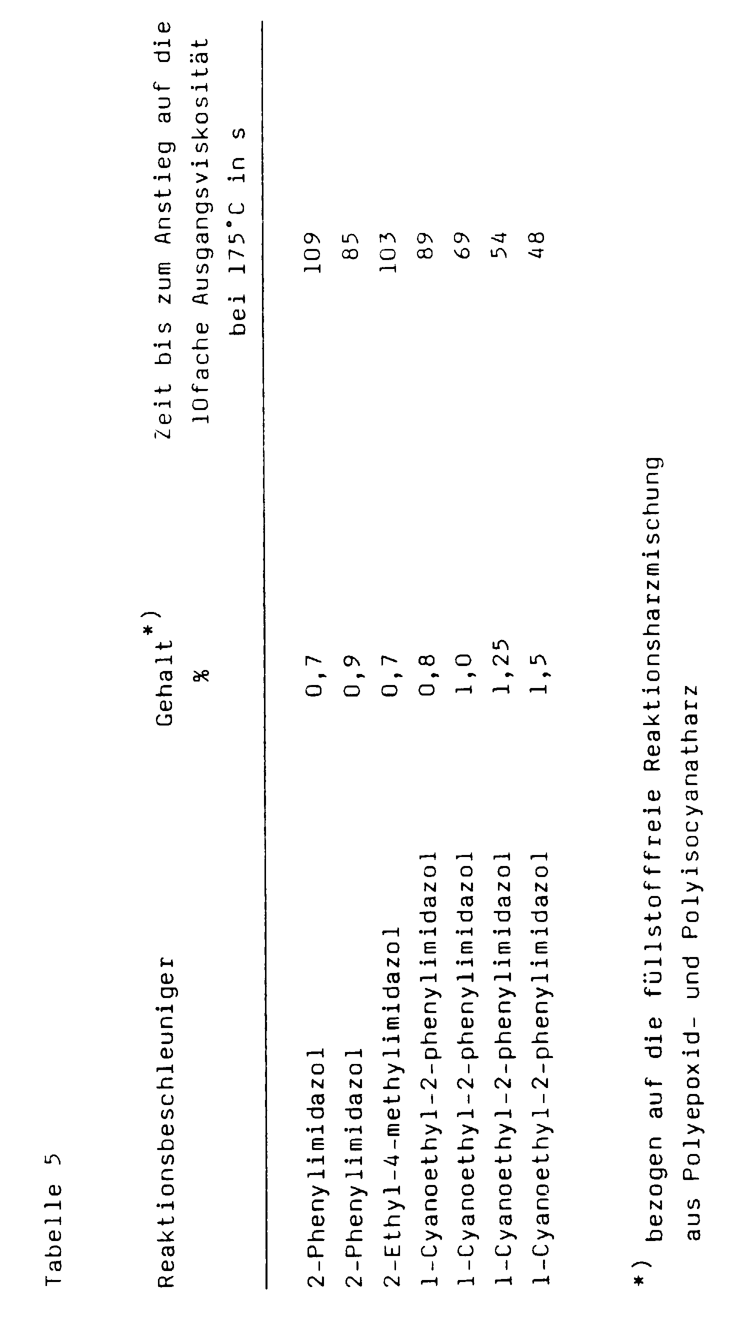

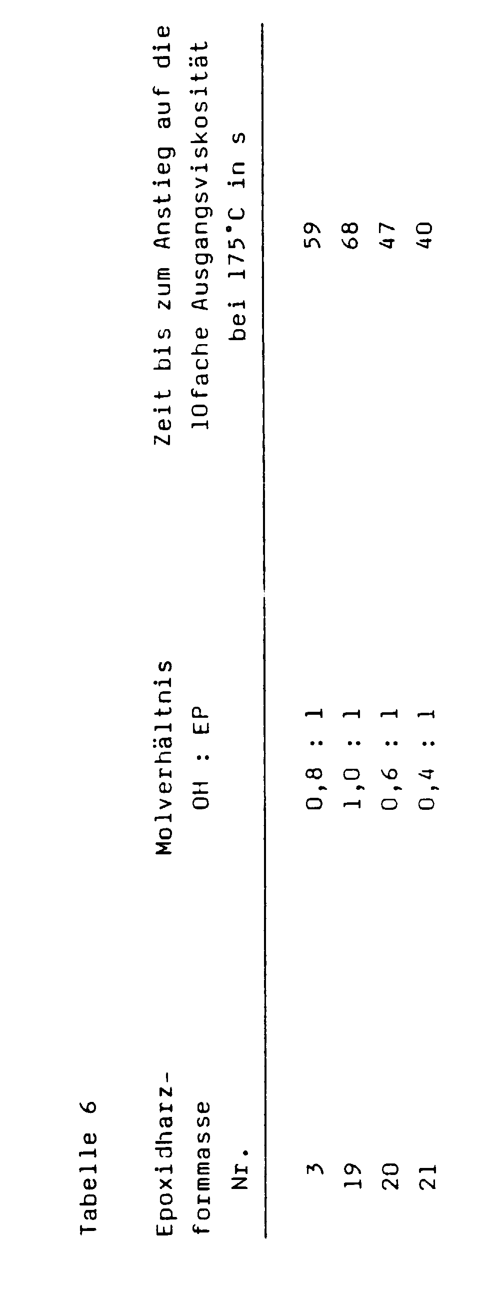

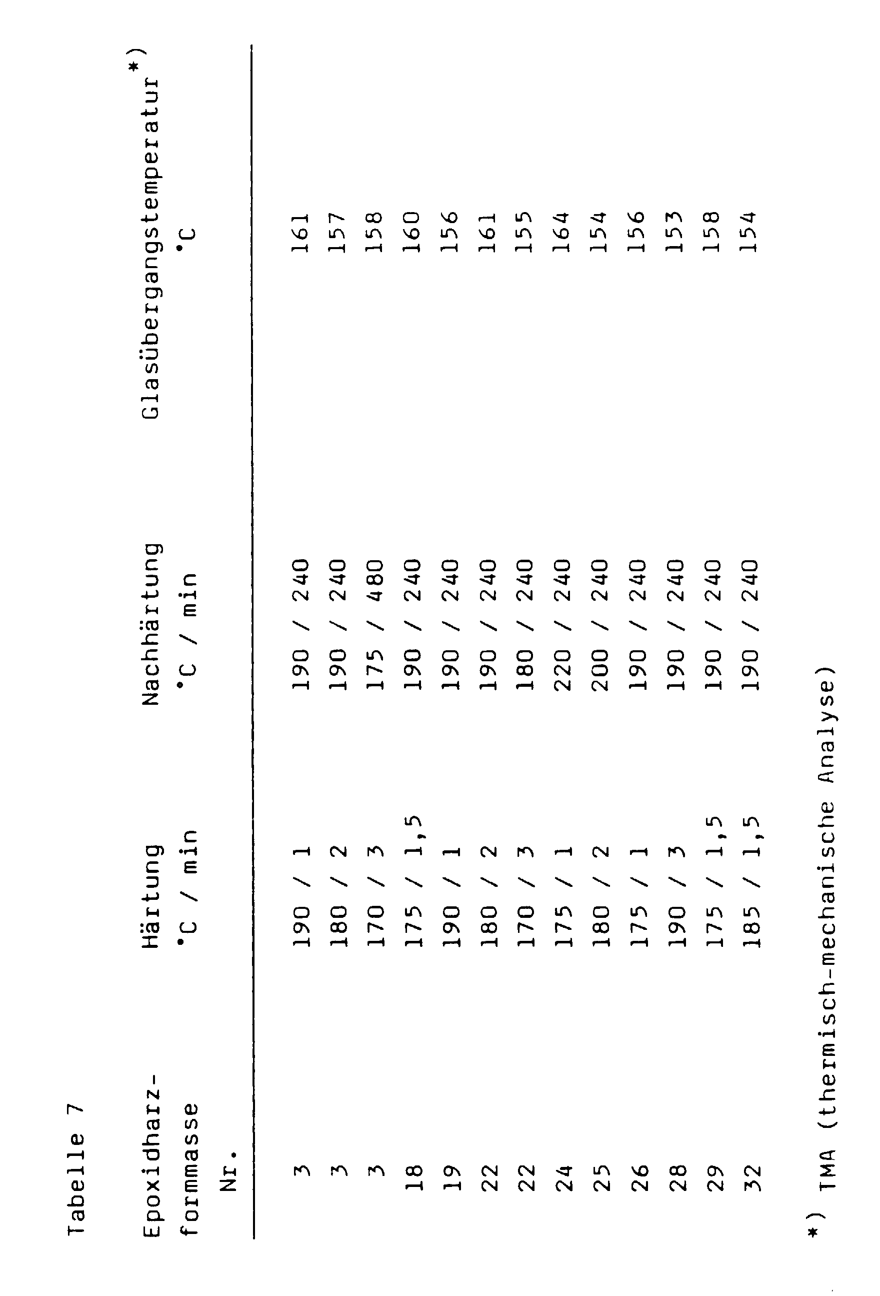

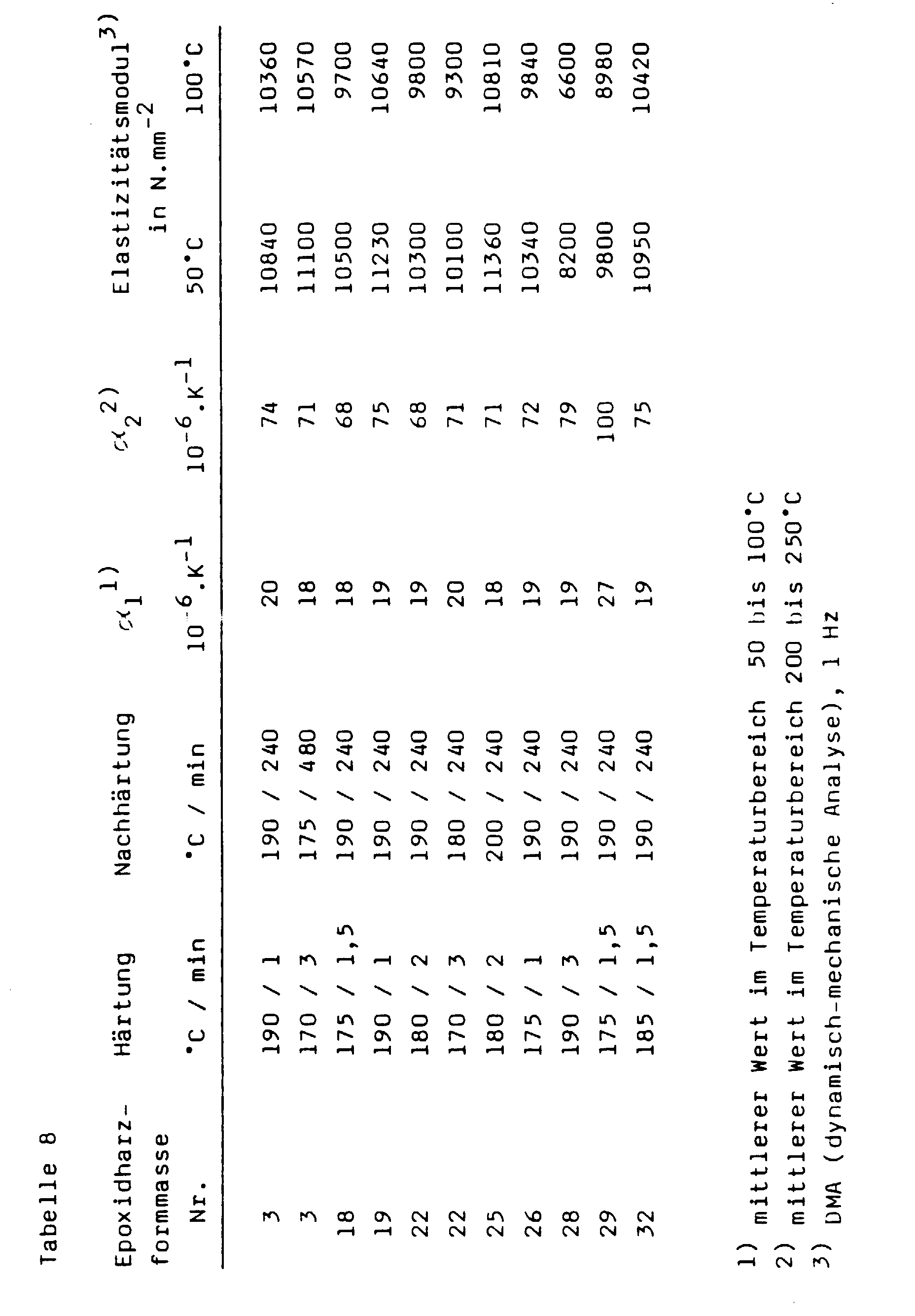

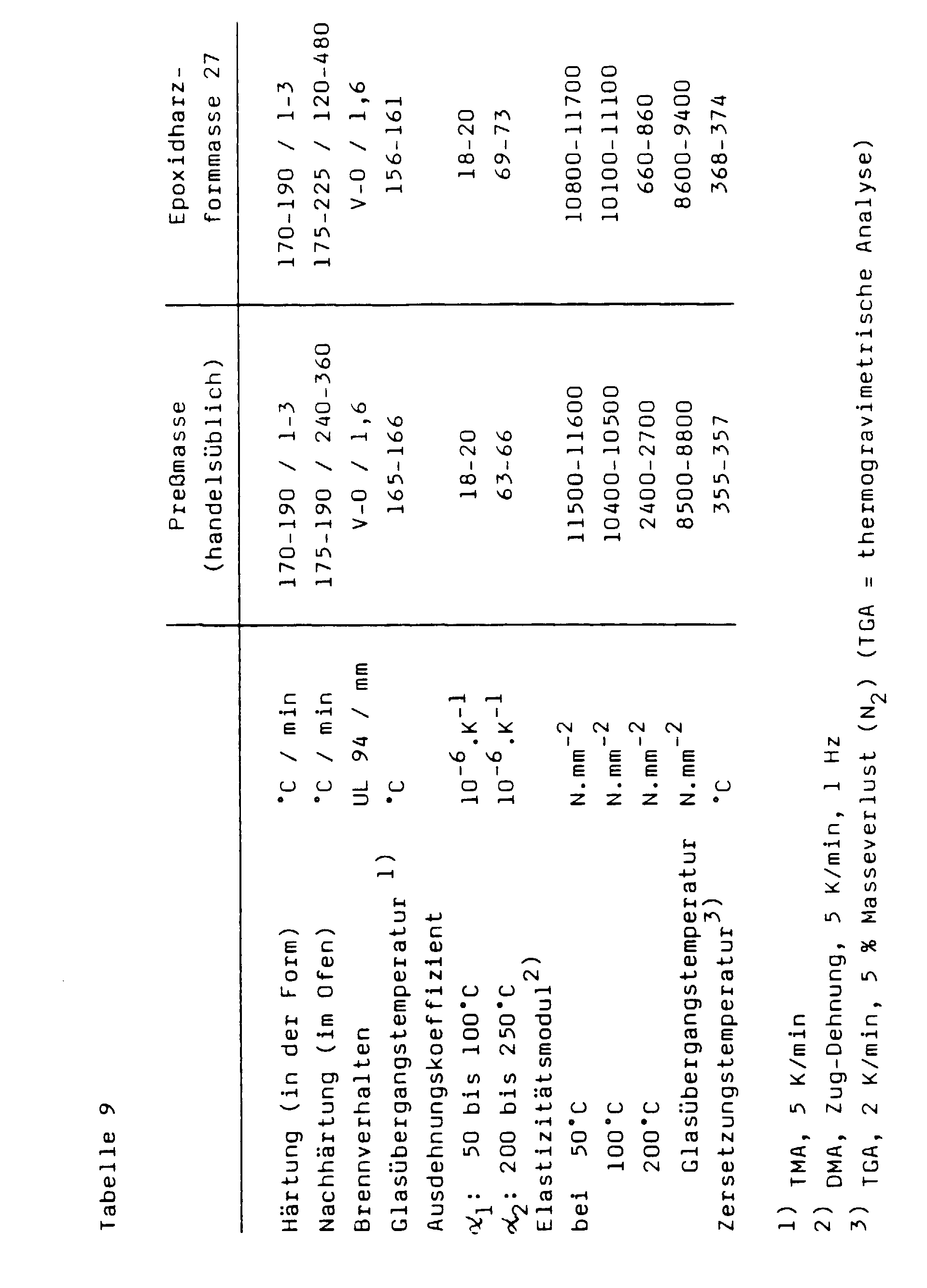

## Patentansprüche

1. Verfahren zur Herstellung einer flammwidrig eingestellten, rieselfähigen, latent reaktiven, phenolisch härtbaren Epoxidharzformmasse zur Umhüllung von Bauelementen der Elektronik, **dadurch gekennzeichnet,** daß aus einer Füllstoff enthaltenden, thermisch polymerisierbaren Reaktionsharzmischung von Polyepoxidharz, bestehend aus einer Mischung von di- und mehrfunktionellen Epoxidharzen, und Polyisocyanatharz mit einem Molverhältnis der Epoxidgruppen zu den Isocyanatgruppen > 1 - unter Verwendung von substituiertem Imidazol als Reaktionsbeschleuniger in einer Konzentration von 0,5 bis 2,5 %, bezogen auf Polyepoxidharz - bei Reaktionstemperaturen bis 200°C eine isocyanatgruppenfreie, latent reaktive prepolymere Epoxidharzmischung in Pulverform hergestellt wird, und daß die Epoxidharzmischung mit einer pulverförmigen, Füllstoff enthaltenden Phenolharzmischung im Molverhältnis der Epoxidgruppen zu den phenolischen Hydroxylgruppen von 1:0,4 bis 1:1,1 vermischt wird, gegebenenfalls unter Zusatz von Additiven.

2. Verfahren nach Anspruch 1, **dadurch gekennzeichnet,** daß als Epoxidharz ein Bisphenol A- oder Bisphenol F-Epoxidharz, ein Phenolnovolak- oder Kresolnovolak-Epoxidharz, Triglycidylisocyanurat, Tetraglycidyldiaminodiphenylmethan, ein Polyglycidylphosphorharz oder ein Siliconepoxidharz der allgemeinen Formel 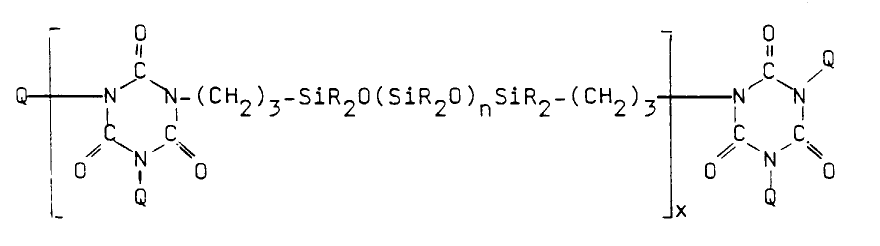 eingesetzt wird, wobei folgendes gilt:
n ist eine ganze Zahl von 0 bis 25,
x ist eine ganze Zahl von 0 bis 3,
R = Alkyl oder Aryl,
Q = -(CH₂)₃SiR₂O(SiR₂O)ₙSiR₂R',
wobei n und R die vorstehend angegebene Bedeutung haben und R' ein epoxyfunktioneller Rest mit 6 C-Atomen ist.

3. Verfahren nach Anspruch 2, **dadurch gekennzeichnet,** daß der Gehalt an Siliconepoxidharz, bezogen auf die füllstofffreie Reaktionsharzmischung aus Polyepoxid- und Polyisocyanatharz, bis zu 20 % beträgt, vorzugsweise 1 bis 7 %.

4. Verfahren nach einem der Ansprüche 1 bis 3, **dadurch gekennzeichnet,** daß in der Epoxidharzmischung das Molverhältnis von mehrfunktionellem zu difunktionellem Epoxidharz, bezogen auf die Epoxidgruppen, 0,2 bis 0,75 beträgt.

5. Verfahren nach einem oder mehreren der Ansprüche 1 bis 4, **dadurch gekennzeichnet,** daß als Polyisocyanatharz ein Isomerengemisch von Diisocyanatodiphenylmethan oder von Toluylendiisocyanat oder ein Prepolymer eines Isomerengemisches von Diisocyanatodiphenylmethan eingesetzt wird.

6. Verfahren nach einem oder mehreren der Ansprüche 1 bis 5, **dadurch gekennzeichnet,** daß in der Reaktionsharzmischung das Molverhältnis der Epoxidgruppen zu den Isocyanatgruppen 1,5:1 bis 4:1 beträgt.

7. Verfahren nach einem oder mehreren der Ansprüche 1 bis 6, **dadurch gekennzeichnet,** daß als Reaktionsbeschleuniger 2-Ethyl-4-methylimidazol, 2-Phenylimidazol oder 1-Cyanoethyl-2-phenylimidazol eingesetzt wird.

8. Verfahren nach einem oder mehreren der Ansprüche 1 bis 7, **dadurch gekennzeichnet,** daß der Gehalt an Reaktionsbeschleuniger 1,0 bis 1,8 % beträgt, bezogen auf Polyepoxidharz.

9. Verfahren nach einem oder mehreren der Ansprüche 1 bis 8, **dadurch gekennzeichnet,** daß als Phenolharz Phenol- oder Kresolnovolake oder Mischungen davon eingesetzt werden.

10. Verfahren nach einem oder mehreren der Ansprüche 1 bis 9, **dadurch gekennzeichnet,** daß die Phenolharzmischung einen Reaktionsbeschleuniger enthält, wobei der Gehalt des Reaktionsbeschleunigers 0,5 bis 1,5 % beträgt, vorzugsweise 0,8 bis 1,2 %, bezogen auf die füllstofffreie Phenolharzmischung.

11. Verfahren nach einem oder mehreren der Ansprüche 1 bis 10, **dadurch gekennzeichnet,** daß mineralische Füllstoffe, wie Quarzgut, und/oder keramische Füllstoffe, wie Aluminiumoxid, eingesetzt werden.

12. Verfahren nach einem oder mehreren der Ansprüche 1 bis 11, **dadurch gekennzeichnet**, daß das Molverhältnis von Epoxidgruppen zu phenolischen Hydroxylgruppen in der härtbaren Epoxidharzformmasse 1:0,6 bis 1:1 beträgt.

## Claims

1. A process for the production of a flame-resistant, pourable, latently reactive, phenolicly curable epoxy resin moulding material for the encapsulation of electronics components, characterised in that a latently reactive, prepolymeric epoxy resin mixture free of isocyanate groups is produced in powdered form from a filler-containing, thermally polymerisable reaction resin mixture of polyepoxy resin, consisting of a mixture of bi- and multi-functional epoxy resins, and polyisocyanate resin with a molar ratio of the epoxy groups to the isocyanate groups of > 1 using substituted imidazole as reaction accelerator in a concentration of 0.5 to 2.5 % relative to polyepoxy resin at reaction temperatures up to 200°C, and that the epoxy resin mixture is mixed with a powdered, filler-containing phenolic resin mixture in a molar ratio of the epoxy groups to the phenolic hydroxyl groups or 1 : 0.4 to 1 : 1.1, optionally with the addition of additives.

2. A process according to Claim 1, characterised in that as epoxy resin there is used a bisphenol A- or bisphenol F- epoxy resin, a phenol novolak or cresol novolak epoxy resin, triglycidyl isocyanurate, tetraglycidyl diaminodiphenyl methane, a polyglycidyl phosphorus resin or a silicone epoxy resin of the general formula 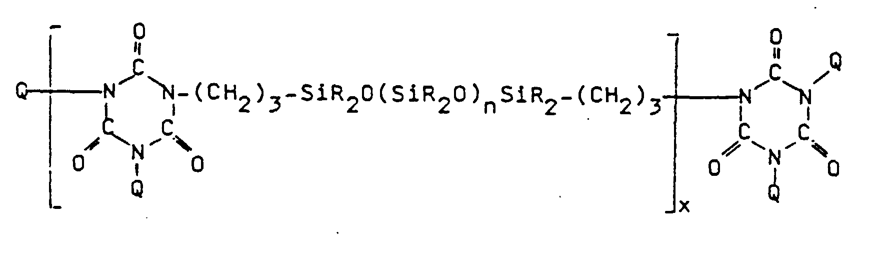 wherein
n is a whole number from 0 to 25,
x is a whole number from 0 to 3,
R = alkyl or aryl
Q = -(CH₂)₃SiR₂O(SiR₂O)ₙSiR₂R'
wherein n and R have the meaning indicated above and R' is an epoxy-functional group having 6 C-atoms.

3. A process according to Claim 2, characterised in that the content of silicone epoxy resin, relative to the filler-free reaction resin mixture of polyepoxy- and polyisocyanate resin, amounts to up to 20 %, preferably 1 to 7 %.

4. A process according to one of Claims 1 to 3, characterised in that in the epoxy resin mixture the molar ratio of multi-functional to bi-functional epoxy resin, relative to the epoxy groups, is 0.2 to 0.75.

5. A process according to one or more of Claims 1 to 4, characterised in that an isomer mixture of diisocyanatodiphenyl methane or of toluylene diisocyanate or a prepolymer of an isomer mixture of diisocyanatodiphenyl methane is used as polyisocyanate resin.

6. A process according to one or more of Claims 1 to 5, characterised in that in the reaction resin mixture the molar ratio of the epoxy groups to the isocyanate groups amounts to 1.5 : 1 to 4 : 1.

7. A process according to one or more of Claims 1 to 6, characterised in that 2-ethyl-4-methylimidazole, 2-phenylimidazole or 1-cyanoethyl-2-phenylimidazole is used as reaction accelerator.

8. A process according to one or more of Claims 1 to 7, characterised in that the content of reaction accelerator amounts to 1.0 to 1.8 % relative to polyepoxy resin.

9. A process according to one or more of Claims 1 to 8, characterised in that phenol- or cresol novolaks or mixtures thereof are used as phenolic resin.

10. A process according to one or more of Claims 1 to 9, characterised in that the phenolic resin mixture contains a reaction accelerator, the content of the reaction accelerator amounting to 0.5 to 1.5 %, preferably 0.8 to 1.2 %, relative to the filler-free phenolic resin mixture.

11. A process according to one or more of Claims 1 to 10, characterised in that mineral fillers, such as fused quartz, and/or ceramic fillers, such as aluminium oxide, are used.

12. A process according to one or more of Claims 1 to 11, characterised in that the molar ratio of epoxy groups to phenolic hydroxyl groups in the curable epoxy resin moulding material is 1 : 0.6 to 1 : 1.

## Revendications

1. Procédé de fabrication d'une masse à mouler en résine époxy ignifugée, à écoulement libre, à réactivité latente et durcissable phénoliquement pour le revêtement de composants électroniques, caractérisé en ce qu'on prépare à partir d'une composition de résine de réaction thermiquement polymérisable contenant une matière de charge, de résine polyépoxy, constituée d'une composition de résines époxy di- et polyfonctionnelles, et de résine polyisocyanate avec un rapport molaire des groupes époxy aux groupes isocyanates > 1 - en utilisant de l'imidazole substitué à titre d'accélérateur de réaction en une concentration de 0,5 à 2,5 %, par rapport à la résine polyépoxy - à des températures de réaction jusqu'à 200 °C, une composition de résine époxy prépolymère à réaction latente et exempte de groupes isocyanates sous forme de poudre, et en ce que la composition de résine époxy est mélangée à une composition de résine phénolique sous forme de poudre, contenant une matière de charge, dans un rapport molaire des groupes époxy aux groupes hydroxyles phénoliques de 1 : 0,4 à 1 : 1,1, en ajoutant éventuellement des additifs.

2. Procédé selon la revendication 1, caractérisé en ce qu'on utilise à titre de résine époxy une résine époxy de bisphénol A ou de bisphénol F, une résine époxy de phénol-novolaque ou de crésol-novolaque, de l'isocyanurate triglycidylique, du tétraglycidyldiaminodiphénylméthane, une résine de polyglycidylphosphore ou une résine époxy de silicone répondant à la formule générale 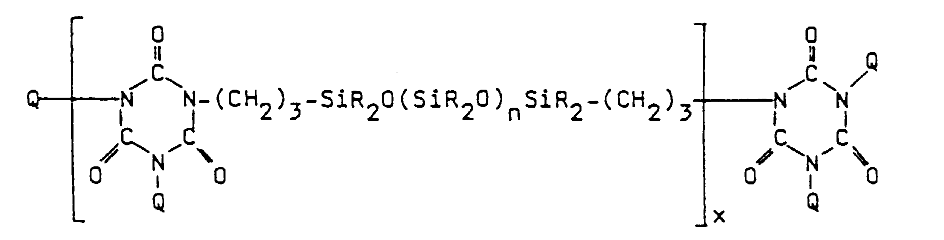 où vaut ce qui suit :
n est un nombre entier de 0 à 25,
x est un nombre entier de 0 à 3,
R représente un groupe alkyle ou un groupe aryle,
Q représente un groupe -(CH₂)₃SiR₂O(SiR₂O)ₙSiR₂R',
où n et R présentent la signification indiquée précédemment et R' est un résidu époxy fonctionnel avec 6 atomes de carbone.

3. Procédé selon la revendication 2, caractérisé en ce que la teneur en résine époxy de silicone, par rapport à la composition de résine de réaction exempte de matière de charge, constituée de résine polyépoxy et polyisocyanate vaut jusqu'à 20 %, de préférence de 1 à 7 %.

4. Procédé selon l'une des revendications 1 à 3, caractérisé en ce que, dans le mélange de résine époxy, le rapport molaire de la résine époxy polyfonctionnelle à la résine époxy difonctionnelle, par rapport aux groupes époxy, vaut 0,2 à 0,75.

5. Procédé selon une ou plusieurs des revendications 1 à 4, caractérisé en ce que, à titre de résine polyisocyanate, on utilise un mélange d'isomères de diisocyanatodiphénylméthane ou de diisocyanate de toluène ou un prépolymère d'un mélange d'isomères de diisocyanatodiphénylméthane.

6. Procédé selon une ou plusieurs des revendications 1 à 5, caractérisé en ce que dans la composition de résine de réaction le rapport molaire des groupes époxy aux groupes isocyanates vaut 1,5 : 1 à 4 : 1.

7. Procédé selon une ou plusieurs des revendications 1 à 6, caractérisé en ce qu'on utilise à titre d'accélérateur de réaction du 2-éthyl-4-méthylimidazole, du 2-phénylimidazole ou du 1-cyanoéthyl-2-phénylimidazole.

8. Procédé selon une ou plusieurs des revendications 1 à 7, caractérisé en ce que la teneur en accélérateur de réaction vaut 1,0 à 1,8 %, par rapport à la résine polyépoxy.

9. Procédé selon une ou plusieurs des revendications 1 à 8, caractérisé en ce qu'on utilise à titre de résine phénolique des phénol-novolaques ou des crésol-novolaques, ou des mélanges de celles-ci.

10. Procédé selon une ou plusieurs des revendications 1 à 9, caractérisé en ce que la composition de résine phénolique contient un accélérateur de réaction, la teneur en accélérateur de réaction valant 0,5 à 1,5%, de préférence 0,8 à 1,2 %, par rapport à la composition de résine phénolique exempte de matière de charge.

11. Procédé selon une ou plusieurs des revendications 1 à 10, caractérisé en ce qu'on utilise des matières de charge minérales, telles que la silice vitreuse et/ou des matières de charge céramiques, telles que l'oxyde d'aluminium.

12. Procédé selon une ou plusieurs des revendications 1 à 11, caractérisé en ce que le rapport molaire des groupes époxy aux groupes hydroxyles phénoliques dans la masse à mouler de résine époxy durcissable vaut 1 : 0,6 à 1 : 1.
